# EUROPEAN PATENT APPLICATION

(11) **EP 1 788 367 A1**
(43) Date of publication of application: **23.05.2007**
(21) Application number: 05781985.6
(22) Date of filing: 09.09.2005
(51) Int. Cl.: G01H 11/08, H01H 36/00, G01L 1/16, H01L 41/08

(54) **VIBRATION DETECTING SENSOR AND PRESSURE SENSITIVE SWITCH USING CABLE-SHAPED PIEZOELECTRIC ELEMENT**

(30) Priority: 10.09.2004 JP 2004264179; 10.09.2004 JP 2004263974; 10.09.2004 JP 2004263973
(71) Applicant: MATSUSHITA ELECTRIC INDUSTRIAL CO., LTD., Osaka 571-8501 (JP)
(72) Inventor: UEDA, Shigeki c/o Matsushita Ind. Co.Ltd., Chuo-ku, Osaka 540-6319 (JP); OGINO, Hiroyuki c/o Matsushita Ind. Co.Ltd., Chuo-ku, Osaka 540-6319 (JP); KANEKO, Hideki c/o Matsushita Ind. Co.Ltd., Chuo-ku, Osaka 540-6319 (JP); KAWAI, Miyuki c/o Matsushita Ind. Co.Ltd., Chuo-ku, Osaka 540-6319 (JP); MATSUDA, Masato c/o Matsushita Ind. Co.Ltd., Chuo-ku, Osaka 540-6319 (JP)
(74) Representative: Grünecker, Kinkeldey, Stockmair & Schwanhäusser Anwaltssozietät
(86) International application number: PCT/JP2005/016656
(87) International publication number: WO 2006/028222

(57) **Abstract**

A challenge to be met by the present invention is to provide a vibration detection sensor which can be applied to various instruments or fields requiring accurate detection and measurement of vibration.

A vibration detection sensor (100) has a substrate (2), and a cable-shaped pi ezoelectric element (1) connected directly to at least one end of the substrate. The cable-shaped piezoelectric element (1) has along a radial direction thereof a core electrode (3), a piezoelectric member (5) disposed around the core electrode, an outer electrode (7) disposed around the piezoelectric member, and a sheathing layer (9) disposed around the outer electrode.

## Description

### TECHNICAL FIELD

The present invention relates to a vibration detection sensor using a cable-shaped piezoelectric element, as well as to a pressure-sensitive switch.

### BACKGROUND ART

Various vibration detectors have hitherto been known as seismoscopes for detecting an earthquake or as pressure-sensitive sensors. Of these vibration detectors, vibration detectors employing predetermined piezoelectric elements have already been known.

For instance, Patent Document 1 describes a vibration sensor having a piezoelectric element provided upright on a printed substrate in a swayable manner.

When subjected to external vibration, the piezoelectric element becomes deformed and computes seismic intensity from a longitudinal level of a voltage having developed between two electrodes attached to an outer peripheral surface of the piezoelectric element.

For instance, a microswitch shown in Fig. 51 has hitherto been known as a switch used in various applications (see, e.g., Patent Document 2).
When pushing pressure has been exerted on a lever 1002 of a microswitch 1001, the lever 1002 arrives at the position of a push button 1003. If the pushing pressure exerted on the push button 3 by the lever 1002 is sufficient for actuating the push button 1003, a movable terminal 1004 contacts a contact point 1005, thereby activating the switch.

Further,variousvibration detectorshave heretofore been known as seismoscopes for detecting an earthquake or as pressure-sensitive elements used in electrical appliances or the like. Of these vibration detectors, vibration detectors using a predetermined piezoelectric element have been known.

For instance, Patent Document 3 describes a seismoscope where a coaxial piezoelectric element is spirally provided while one end thereof is fixed and the other end thereof is provided with a vibration-sensing element.

Patent Document 4 describes apressure-sensitive element,
in which a pressure-sensitive body formed from a piezoelectric element is concentrically provided outside an inner electrode, and an exterior of the pressure-sensitive body is coated with metallic foil, an outer electrode, or an insulation material.

When subjected to force, such as contraction/expansion, bending, or the like, from an external object, the piezoelectric element becomes deformed, to thereby generate a predetermined voltage (a piezoelectric effect). Especially, this piezoelectric element detects an acceleration stemming from application of force of the object, and produces an output in response to the acceleration. By utilization of such a characteristic, the piezoelectric element is utilized for a seismoscope, a sensor for detecting predetermined stress or pressure such as a pressure-sensitive element, or a switch which is activated/deactivated in response to detection.

The pressure-sensitive element using such an existing piezoelectric element possesses resilience and can be fixedly placed at a predetermined location while being deformed in a desired shape. A method for mechanically fixing an element in a mount section by use of an adhesive, a thread, an elastic element, resin, or the like, is used for fixing.

Patent Document 1: JP-A-2001-108516
Patent Document 2: JP-A-2000-215751
Patent Document 3: JP-A-11-064096
Patent Document 4: JP-A-11-160169

### DISCLOSURE OF THE INVENTION

### PROBLEM TO BE SOLVED BY THE INVENTION

However, in the vibration-sensitive sensor, a piezoelectric element is provided upright on the printed substrate, or a piezoelectric element is suspended from the printed substrate. With this configuration, limitations are imposed on the degrees of freedom of a direction in which the sensor is attached. Further, in order to maintain a predetermined height, a space responsive to the height must be ensured. Moreover, a problem is conceived to exist in the accuracy of detection of horizontal vibration.

In the microswitch described in Patent Document 2, bringing the movable terminal 1004 into contact with the contact point 1005 requires pushing pressure sufficient for pressing the lever 1002 and the push button 1003 and a stroke S sufficient for pushing the lever 1002. If the pressure used for pushing the lever 1002 and the push button 1003 is minute or the stroke S used for pushing the lever 1002 is short, the switch is not activated.

Moreover, since the pressure-sensitive element itself possesses resilience, the element retains the property of still attempting to restore its original shape (a remaining shape restoration characteristic) evenwhen the element has been fixed while being deformed in a desired shape. Therefore, when predetermined force has been applied to the element from the outside, an output derived from the shape restoration characteristic as well as an output (a correct output) originating from deformation caused by application of force can also arise. The output originating from the shape restoration characteristic assumes various values according to a deformed shape or a fixing method, and hence there exists a problem of an output of the fixedly-placed element failing to be obtained stably.

The present invention provides a vibration detection sensor capable of detecting vibration with high accuracy while ensuring degrees of freedom of attachment.

The present invention has been conceived in light of the drawbacks, and an objective of the present invention is to provide a pressure-sensitive switch capable of outputting a signal in response to an acceleration of an applied pushing pressure regardless of the strength or weakness of the pushing pressure or the length of a push stroke.

The present invention also provides a cable-shaped piezoelectric element capable of obtaining a stable output while achieving a desired shape, as well as providing a vibration detection sensor using the element.

### MEANS FOR SOLVING THE PROBLEM

A vibration detection sensor of the present invention comprises a substrate, and a cable-shaped piezoelectric element serially connected to at least one end of the substrate. The cable-shaped piezoelectric element has, in a radial direction thereof, a core electrode, a piezoelectric member disposed around the core electrode, an outer electrode disposed around the piezoelectric member, and a sheathing layer disposed around the outer electrode.

The cable-shaped piezoelectric element is formed so as to have a bend section, and a weight may be fixed to at least a portion of the cable-shaped piezoelectric element.

The cable-shaped piezoelectric element may be bent so as to become substantially circular within a plane substantially parallel to a main plane of the substrate, and may have a weight fastened to an open end thereof opposite the end thereof fixed to the substrate.

The cable-shaped piezoelectric element may be connected to the substrate while both ends thereof are arranged in substantially parallel to each other, and an intermediate portion between both ends may be formed into a substantially circular shape.

The cable-shaped piezoelectric element can be formed into the shape of a coil and provided at substantially right angles on the substrate. In the meantime, the cable-shaped piezoelectric element may be formed into the shape of a coil and extended from the substrate such that the diameter of the coil increases with increasing distance from the substrate.

In the meantime, a through hole may be formed in the substrate, the cable-shaped piezoelectric element connected to the substrate so as to become substantially parallel to a principal plane of the substrate within the through hole, and a weight may be fastened to an open end of the cable-shaped piezoelectric element opposite an end thereof fixed to the substrate. Alternatively, the cable-shaped piezoelectric element may be bent into substantially U-shape, and the cable-shaped piezoelectric element may be at both ends thereof fixed to the substrate.

The substrate and the cable-shaped piezoelectric element may be housed in a predetermined enclosure.

The cable-shaped piezoelectric element may be connected to the substrate such that the cable-shaped piezoelectric element is suspended from a lower surface of the substrate so as to extend downward.

The cable-shaped piezoelectric element can be imparted with a shape-retaining characteristic. The piezoelectric member can comprise resin and piezoelectric ceramic.

The vibration detection sensor of the present invention can be used for a seismoscope, a flow rate measuring instrument, an electrical buggy, an electrical wheelchair, and the like.

The present invention also relates to a pressure-sensitive switch comprising a piezoelectric cable which has a piezoelectric element structure formed from piezoelectric ceramic fine particles and resin-based material. At least a portion of the piezoelectric cable is caused to protrude from a supporting face, the protruding portion is bent into a bend section, and a control circuit is connected to a base end portion of the piezoelectric cable.

The present invention is also characterized in that a clearance is provided between the bend section of the piezoelectric cable and the supporting face.

The present invention is also characterized in that the bend section of the piezoelectric cable is bend at a single curvature.

The present invention is also characterized by further comprising:
fixing means for fixing a leading end portion of the piezoelectric cable.

A cable-shaped piezoelectric element of the present invention has a shape-retaining characteristic and comprises along a radial direction thereof at least: a core electrode, a piezoelectric member disposed around the core electrode, an outer electrode disposed around the piezoelectric element, and a sheathing layer provided around the outer electrode.

A cable-shaped piezoelectric element of the present invention has along a radial direction thereof : a core electrode, a piezoelectric member disposed around the core electrode, an outer electrode disposed around the piezoelectric member, and a sheathing layer provided around the outer electrode. The element further comprises a shape-retaining member which is interposed between the outer electrode and the sheathing layer in the radial direction and retains the cable-shaped piezoelectric element in a predetermined shape.

The shape retaining member can be formed from at least one of a leaf spring and a coil spring.

A cable-shaped piezoelectric element of the present invention comprises along a radial direction thereof: a core electrode, a piezoelectric member disposed around the core electrode, an outer electrode disposed around the piezoelectric member, and a sheathing layer provided around the outer electrode. The core electrode has a shape-retaining characteristic for retaining the cable-shaped piezoelectric element in a predetermined shape. The core electrode can be formed from a shape memory alloy.

A cable-shaped piezoelectric element of the present invention also comprises along a radial direction thereof: a core electrode, a piezoelectric member disposed around the core electrode, an outer electrode disposed around the piezoelectric member, and a sheathing layer provided around the outer electrode. The sheathing layer has a shape-retaining characteristic for retaining the cable-shaped piezoelectric element into a predetermined shape. The sheathing layer can be formed from a heat-shrinkable tube.

In the cable-shaped piezoelectric element, the piezoelectric member can be formed from resin and piezoelectric ceramic. The predetermined shape may be at least one of the shape of a coil, a circular shape, the shape of a segment, a corrugated shape, and the shape of a vortex.

A vibration detection sensor can be manufactured by combination of the above cable-shaped piezoelectric element and a control circuit for detecting a signal output from the cable-shaped piezoelectric element.

A crime prevention fence or a nurse call switch can be manufactured from the above cable-shaped piezoelectric element.

### ADVANTAGES OF THE INVENTION

The vibration detection sensor of the present invention uses a predetermined cable-shaped piezoelectric element capable of adopting various shapes. Hence, an attachment which is not limited by a mounting direction, a mount location, a mount space, and the like and exhibits a high degree of freedom can be ensured. Consequently, the degree of design freedom of equipment using the sensor is also enhanced. Moreover, the vibration detection sensor of the present invention enables highly-accurate detection without elaborately, previously specifying the direction of vibration.

According to the present invention, at least a portion of the piezoelectric cable protruding from the supporting face is bent. Accordingly, the amount of mechanical flexion of a piezoelectric member is increased. By application of stress to the bend section, an applied pushing pressure can be detected with high sensitivity even when the pushing pressure is weak or the stroke is short in response to fluctuations of the pushing pressure or the pushing stroke length, a signal responding to the acceleration of the pushing pressure can be output.

A clearance is provided between the bend section of the piezoelectric cable and the supporting face thereof, whereby the amount of displacement in the piezoelectric cable achieved during pushing can be made wide. Thus, a wide detection range can be ensured.
Moreover, the bend section of the piezoelectric cable is curved at the same curvature, whereby sensitivity can be uniformly enhanced over the entire bend section.

According to the present invention, there can be provided a cable-shaped piezoelectric element capable of stably ensuring a desired shape and producing a stable output, a vibration detection sensor using the same, and another product using the cable-shaped piezoelectric element.

### BRIEF DESCRIPTION OF THE DRAWINGS

[Fig. 1] A view of an example cable-shaped piezoelectric element using a coil spring as a shape-retaining member.
[Fig. 2] A view of an example cable-shapedpiezoelectric element using a leaf spring as the shape-retaining member.
[Fig. 3] Aview of an example cable-shaped piezoelectric element in which a core electrode and/or a sheathing layer is imparted with a shape-retaining characteristic.
[Fig. 4] A schematic diagram showing a vibration detection sensor system using the cable-shaped piezoelectric element.
[Fig. 5] A view showing a vibration detection sensor according to a first embodiment of the present invention.
[Fig. 6] A view showing a vibration detection sensor according to a second embodiment of the present invention.
[Fig. 7] A view showing a vibration detection sensor according to a third embodiment of the present invention.
[Fig. 8] A view showing a vibration detection sensor according to a fourth embodiment of the present invention.
[Fig. 9] A view showing a vibration detection sensor according to a fifth embodiment of the present invention.
[Fig. 10] A view showing a vibration detection sensor according to a sixth embodiment of the present invention.
[Fig. 11] A view showing a vibration detection sensor according to a seventh embodiment of the present invention.
[Fig. 12] A view showing a vibration detection sensor according to an eighth embodiment of the present invention.
[Fig. 13] Aview showing a vibration detection sensor according to a ninth embodiment of the present invention.
[Fig. 14] A view showing a vibration detection sensor according to a tenth embodiment of the present invention.
[Fig. 15] A view showing a vibration detection sensor according to an eleventh embodiment of the present invention.
[Fig. 16] A view showing a vibration detection sensor according to a twelfth embodiment of the present invention.
[Fig. 17] A view showing a vibration detection sensor according to a thirteenth embodiment of the present invention.
[Fig. 18] A view showing an example application of the vibration detection sensor of the present invention to a flow measurement device.
[Fig. 19] A view showing an example application of the vibration detection sensor of the present invention to an motor-driven buggy.
[Fig. 20] A view showing an example where a cable-shaped piezoelectric element is subjected to end processing.
[Fig. 21] Views showing various examples where a holder for supporting the cable-shaped piezoelectric element is provided on a substrate.
[Fig. 22] Views showing a method for connecting the cable-shaped piezoelectric element to the substrate.
[Fig. 23] Views showing another method for connecting the cable-shaped piezoelectric element to the substrate.
[Fig. 24] Charts showing loads imposed on the cable-shaped piezoelectric element and a sensor output characteristic.
[Fig. 25] A cross-sectional view showing a pressure-sensitive switch according to a fourteenth embodiment of the present invention.
[Fig. 26] A perspective view of the pressure-sensitive switch shown in Fig. 25.
[Fig. 27] A perspective view for describing a piezoelectric cable.
[Fig. 28] A cross-sectional perspective view for describing the structure of a piezoelectric element.
[Fig. 29] Charts showing loads imposed on the pressure-sensitive switch and a signal output characteristic.
[Fig. 30] A cross-sectional view showing a modification of the pressure-sensitive switch of the present invention.
[Fig. 31] A perspective view of the pressure-sensitive switch shown in Fig. 30.
[Fig. 32] A cross-sectional view showing another modification of the pressure-sensitive switch of the present invention.
[Fig. 33] A cross-sectional view showing yet another modification of the pressure-sensitive switch of the present invention.
[Fig. 34] A cross-sectional view showing still another modification of the pressure-sensitive switch of the present invention.
[Fig. 35] A cross-sectional view showing still another modification of the pressure-sensitive switch of the present invention.
[Fig. 36] A cross-sectional view showing still another modification of the pressure-sensitive switch of the present invention.
[Fig. 37] A perspective view of the pressure-sensitive switch shown in Fig. 36.
[Fig. 38] A perspective view showing a modification of the pressure-sensitive switch of the present invention.
[Fig. 39] A cross-sectional view showing another modification of the pressure-sensitive switch of the present invention.
[Fig. 40] A side view of the principal section showing still another modification of the pressure-sensitive switch of the present invention.
[Fig. 41] Aviewof an example cable-shapedpiezoelectric element of the present invention using a coil spring as a shape-retaining member.
[Fig. 42] Aviewof an example cable-shapedpiezoelectric element of the present invention using a leaf spring as the shape-retaining member.
[Fig. 43] A view of an example cable-shapedpiezoelectric element of the present invention, in which a core electrode and/or a sheathing layer is imparted with a shape-retaining characteristic.
[Fig. 44] Views of examples where the cable-shapedpiezoelectric element of the present invention is deformed in various shapes and used for a vibration detection sensor, wherein (a) is an example of a coil-shapedpiezoelectric element, (b) is an example of circular piezoelectric element, (c) is an example of a circular-arc piezoelectric element, (d) is an example of a corrugated piezoelectric element, and (e) is an example of a spirally-shaped piezoelectric element.
[Fig. 45] A schematic diagram of a vibration detection sensor system using the cable-shaped piezoelectric element of the present invention.
[Fig. 46] Aviewofanexamplecable-shapedpiezoelectricelement of the present invention applied to the top of a crime prevention fence.
[Fig. 47] Aview of an example cable-shapedpiezoelectricelement of the present invention applied to a decorated portion of the crime prevention fence.
[Fig. 48] A view of an example cable-shaped piezoelectric element of the present invention applied to a nurse call switch.
[Fig. 49] Views of other example cable-shaped piezoelectric elements of the present invention applied to a nurse call switch. [Fig. 50] Charts showing loads imposed on the cable-shaped piezoelectric element and a sensor output characteristic.
[Fig. 51] A diagrammatic representation showing an example microswitch.

### DESCRIPTION OF REFERENCE NUMERALS

1 CABLE-SHAPED PIEZOELECTRIC ELEMENT
2 SUBSTRATE
3 CORE ELECTRODE
4 WEIGHT
5 COMPOSITE PIEZOELECTRIC LAYER
7 OUTER ELECTRODE
9 SHEATHING LAYER
11 COIL SPRING
13 LEAF SPRING
15 CONTROL CIRCUIT
100, 110, 120, 130, 140, 150, 160, 170, 170, 190, 200, 210, 220 VIBRATION DETECTION SENSORS
1010 PRESSURE-SENSITIVE SWITCH
1012 SUPPORTING FACE
1013 BEND
1014 CONTROL CIRCUIT
1016 CLEARANCE
1020 PIEZOELECTRIC CABLE
1023 STRUCTURE OF PIEZOELECTRIC ELEMENT
1025 PIEZOELECTRIC CERAMIC FINE PARTICLES
1026 RESIN-BASED MATERIAL
2001 CABLE-SHAPED PIEZOELECTRIC ELEMENT
2003 CORE ELECTRODE
2005 COMPOSITE PIEZOELECTRIC LAYER
2007 OUTER ELECTRODE
2009 SHEATHING LAYER
2011 COIL SPRING
2013 LEAF SPRING
2015 CONTROL CIRCUIT
2017 VIBRATION DETECTION SENSOR
2019 CRIME PREVENTION FENCE
2021 CRIME PREVENTION FENCE
2027 NURSE CALL SWITCH

### BEST MODES FOR IMPLEMENTING THE INVENTION

Embodiments of the present invention will be described hereinbelow by reference to the drawings. In the descriptions of the embodiments, those elements which have the same configurations and yield the same working-effects are assigned the same reference numerals, and their repeated explanations are omitted.

### (First Embodiment)

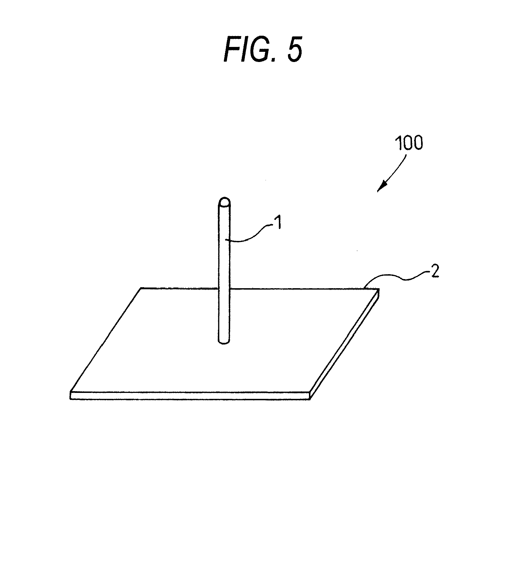

Fig. 5 shows an embodiment of a vibration detection sensor according to the present invention. A vibration detection sensor 100 of the embodiment is formed from a substrate 2, and a cable-shaped piezoelectric element 1 placed on the substrate 2. At least one end (stationary end) of the cable-shaped piezoelectric element 1 is connected directly to the substrate 2, and the other end (open end) of the same is opened.

The vibration detection sensor 100 is used as a seismoscope, or as a sensor for detecting other vibrations. In the present embodiment, the cable-shapedpiezaelectric element 1 is linear, and is laid so as to extend at substantially right angles from the substrate 2.

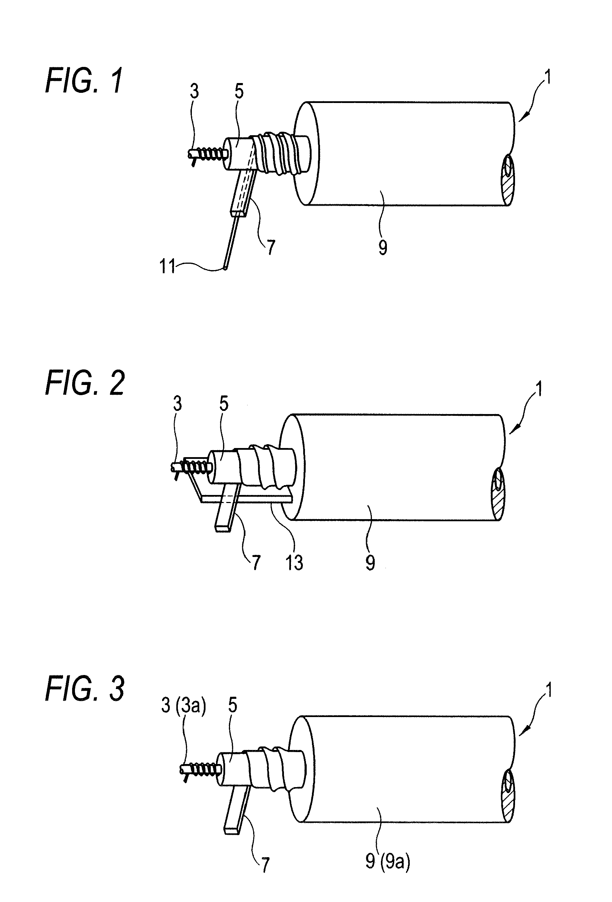

The cable-shaped piezoelectric element 1 has a structure shown in Fig. 1. The cable-shaped piezoelectric element 1 comprises a core electrode (center electrode) 3 placed in the radial center. A piezoelectric element material (composite piezoelectric layer) 5 made of piezoelectric ceramic is provided around the core electrode 3 to thus constitute a piezoelectric member. Moreover, an outer electrode 7 is provided around the composite piezoelectric layer 5, and a coil spring 11 having a shape-retaining characteristic is provided around the outer electrode 7. The outermost circumference of the coil spring 11 is covered with a sheathing layer 9 such as PVC (polyvinyl chloride) or the like, to thus constitute the cable-shaped piezoelectric element 1. The cable-shaped piezoelectric element 1 has a superior shape-retaining characteristic attributable to the coil spring 11, and produces an output signal in response to a deformation acceleration arising at the time of deformation of the cable-shaped piezoelectric element 1. For instance, sintered fine particles of lead titanate or lead-zirconate-titanate, or nonleaded piezoelectric ceramic sintered fine particles such as sodium niobate or the like are used as piezoelectric ceramic. The cable-shaped piezoelectric element 1 of the present embodiment has a flexible characteristic as the piezoelectric cable, and hence can be formed into any shape. This cable is also imparted with a shape-retaining characteristic and, therefore, can be formed and retained in the variety of shapes. In this regard, when the cable-shaped piezoelectric element 1 is used linearly without modification as in the case of the first embodiment, the shape-retaining characteristic is not essential, and hence the coil spring 11 is not indispensable.

In the cable-shaped piezoelectric element 1, a resin-based material, having been uniquely developed by the applicant, being usable up to a temperature of 120°, and possessing heat resistance, is used for the composite piezoelectric layer 5. Thecable-shapedpiezoelectricelement 1 can be used at a temperature range (120°C or less), which is higher than the maximum operating temperature of related-art typical polymeric piezoelectric element material (uniaxially-stretched polyvinylidene fluoride) or a piezoelectric element material (a piezoelectric element material formed from chloroprene and piezoelectric ceramic fine particles) i.e., 90°C. The composite piezoelectric layer 5 is made from resin having flexibility and piezoelectric ceramic and is formed by use of a flexible electrode formed from a coiled metal center electrode and a film-shaped outer electrode, and has the same flexibility as that of an ordinary vinyl cord.

The composite piezoelectric layer 5 is formed from a composite member of resin-based material and a piezoelectric ceramic fine particles of 10µm or less. The vibration detection characteristic is realized by ceramic, and flexibility is realized by resin. The composite piezoelectric layer 5 uses chlorine-based polyethylene as a resin-based material, thereby realizing high heat resistance (120°C), flexibility which enables easy formation, and simple manufacturing processes which do not require a crosslinkage.

The thus-obtained cable-shaped piezoelectric element 1 has no piezoelectric characteristic when the composite piezoelectric layer 5 remains formed. Accordingly, there is required processing (polarization processing) for applying a high DC voltage on the order of volts per millimeter to the composite piezoelectric layer 5, to thereby impart a piezoelectric characteristic to the composite piezoelectric layer 5. When minute imperfections, such as cracks, exist in the composite piezoelectric layer 5, electric discharge tends to arise among the imperfections, so that the electrodes become likely to cause a short-circuit. Accordingly, a sufficient polarized voltage cannot be applied to the composite piezoelectric layer. However, in the present invention, as a result of establishment of unique polarization steps using an auxiliary electrode which can be brought into intimate contact with the composite piezoelectric layer 5 of given length, imperfections are detected and avoided, to thus enable stable polarization. Thereby, the composite piezoelectric layer can also be made longer to tens of meters or more.

In the cable-shaped piezoelectric element 1, a coiled metal center electrode is used for the core electrode 3, and a film-shaped electrode (a three-layer laminate film consisting of aluminum, polyethylene terephthalate, aluminum) is used for the outer electrode 7. Thereby, adhesion between the composite piezoelectric layer 5 and the electrode is ensured, thereby facilitating connection of an external lead wire. Thus, a flexible cable-shaped mount configuration becomes feasible.

The core electrode 3 is formed from a copper-silver alloy coil, the outer electrode 7 is formed from a three-layer laminate film made of aluminum-polyethylene terephthalate-aluminum, and the composite piezoelectric layer 5 is formed from polyethylene-based resin and piezoelectric ceramic fine particles. An outer sheath of the composite piezoelectriclayer 5 is formed from a thermoplastic. According thereto, a dielectric constant of 55, an electric charge of 10 to 13C (coulomb)/gf, and a maximum operating temperature of 120°C can be achieved.

In the cable-shapedpiezaelectric element 1 of the present invention, the coil spring 11 is wound around the exterior of the outer electrode 7. The coil spring 11 is interposed between the outer electrode 7 and the sheathing layer 9 in the radial direction of the cable-shaped piezoelectric element 1. This coil spring 11 forms a shape-retaining member for retaining the cable-shaped piezoelectric element 1 in a predetermined shape.

Although wires provided below can be used as the material of the coil spring 11, the material is not limited to the wire.
WC(80C) (a hard steel wire); SWPA, SWPB (musical instrument wires);
SWOSM-B (a silicon-manganese steel wire); SWOSC-V (a silicon-chromium steel wire);
SUS304-WPB, SUS316-WPA (a stainless steel wire);
BsW (a brass wire); PBW (a phosphor bronze wire).

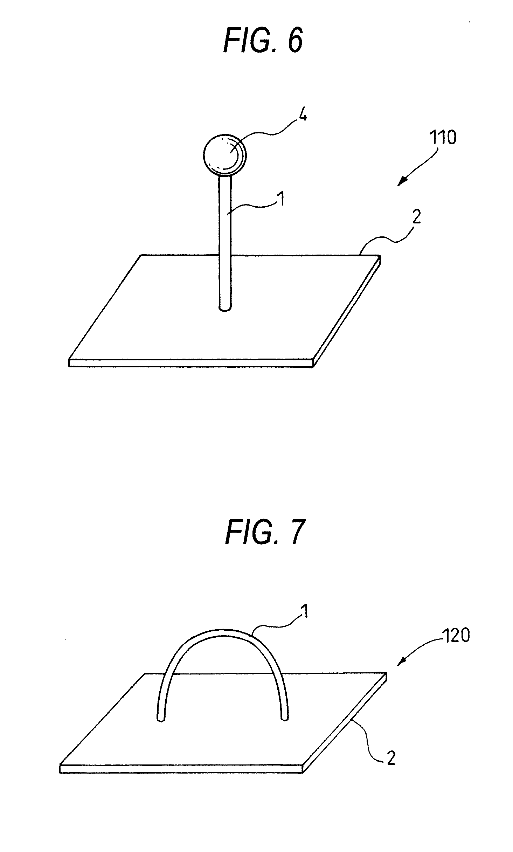

Byway of an example, the above cable-shapedpiezoelectric element 1 is manufactured through the following processes. At the outset, a chlorinated polyethylene sheet and 40% to 70% by volume of piezoelectric ceramic (lead-zirconate-titanate in this embodiment) fine particles are uniformly mixed into the shape of a sheet by means of a rolling technique. After this sheet is finely fragmented into pellets, the pellets are consecutively pushed in conjunction with the core electrode 3, to thus form the composite piezoelectric layer 5 (a piezoelectric element material before being subjected to polarization processing). An auxiliary electrode is brought into contact with the outer circumference of the composite piezoelectric layer, and a high voltage is applied between the auxiliary electrode and the core electrode 3, thereby effecting polarization processing. The outer electrode 7 is then wound around the composite piezoelectric layer. After the coil spring 11 has been wound around the outer electrode 7, the sheathing layer 9 is continuously extruded while sheathing the outer electrode 7 and the coil spring 11. The thus-manufactured cable-shaped piezoelectric element 1 canbe used even in a linear state such as that shown in Fig. 5, but is particularly preferable in a case where the cable-shaped piezoelectric element is processed into any of various shapes such as those shown in Fig. 7 and the like.

When the piezoelectric ceramic fine particles are added to chlorinated polyethylene, it is preferable to previously immerse the piezoelectric ceramic fine particles into an aqueous solution of titanium coupling agent and to dry the thus-immersed piezoelectric ceramic fine particles. Through this processing, the surfaces of the piezoelectric ceramic fine particles are coated with a hydrophilic group and a hydrophobic group, both of which are contained in the titanium coupling agent. The hydrophilic group prevents coagulation of piezoelectric ceramic fine particles, and the hydrophobic group increases wettability of chlorinated polyethylene and the wettability of the piezoelectric ceramic fine particles. Consequently, a large quantity of piezoelectric ceramic fine particles can be uniformly added to the chlorinated polyethylene up to a maximum of 70% by volume. The same effect is found to be attained when, in place of immersion of the piezoelectric ceramic fine particles into the aqueous solution of the titanium coupling agent, a titanium coupling agent is added at the time of rolling of chlorinated polyethylene and the piezoelectric ceramic fine particles. This processing is superior in that special processing for immersing the piezoelectric ceramic fine particles into the aqueous solution of titanium coupling agent is not required. As above, the chlorinated polyethylene also plays a role as binder resin used at the time of mixing of the piezoelectric ceramic fine particles.

In the present embodiment, a single wire formed from copper-based metal is used for the core electrode 3. Further, a strip electrode, which is formed by bonding an aluminum metal film on a polymer layer, is used for the outer electrode 7, and the outer electrode 7 is wrapped around the piezoelectric element material 5. Polyethylene terephthalate (PET) is used as the polymer layer. Since an electrode, which is formed by bonding an aluminum thin film on the PET, is commercially mass-produced and inexpensive, such an electrode is preferable as the outer electrode 7. When this electrode is connected to an external control circuit, or the like, the electrode can be connected by means of, e.g., caulking or an eyelet. There also be adopted a configuration for soldering a single metal wire or a metal braided wire around the aluminum thin film of the outer electrode 7, for use in connection with a control circuit or the like. Since soldering becomes available, working can be made efficient. In order to shield the cable-shaped piezoelectric element 1 from electrical noise in the external environment, the outer electrode 7 is desirably coiled around the compositepiezoelectric layer so that theypartiallyoverlap each other.

Arubbermaterial, which is superior to polyvinyl chloride in terms of heat insulation and waterproofing, can also be used as the sheathing layer 9. In order to make the composite piezoelectric layer 5 easily deformed by pushing force of an article which contacts the composite piezoelectric layer 5, the rubber material, which is softer and more flexible than the composite piezoelectric layer 5, is preferable. Components to be mounted on a vehicle are selected in consideration of heat resistance and cold resistance, and selecting components whose flexibility less drops at -30°C to 85°C is desirable. For instance, it is better to use ethylene-propylene-diene-methylene rubber (EPDM), chloroprene rubber (CR), isobutylene-isoprene rubber (IIR), silicon rubber (Si), thermoplastic elastomer, and the like, as such a rubber material. By means of such a configuration, the smallest curvature of the cable-shaped piezoelectric element 1 can be reduced to a radius of 5 mm. As compared with vinyl chloride, these materials provide greatly superior heat resistance and waterproofing.

As mentioned above, the composite piezoelectric member of the cable-shaped piezoelectric element 1 has both the flexibility of chlorinated polyethylene and the high heat resistance of the piezoelectric ceramic. Hence, a drop in sensitivity, which arises at high temperatures as in a related-art piezoelectric sensor using polyvinylidene fluoride as a piezoelectric member, does not occur in the cable-shaped piezoelectric element 1. Further, in addition to having superior high heat resistance, the cable-shaped piezoelectric element 1 does not require a vulcanizing process which would be required during molding operation as in the case of rubber such as EPDM. Therefore, there is yielded an advantage of superior production efficiency.

Fig. 2 shows a modification of the cable-shaped piezoelectric element 1. In this modification, a leaf spring 13 is placed, in lieu of the coil spring 11 shown in Fig. 1, adjacent to the outer electrode 7. Accordingly, the leaf spring 13 is interposed between the outer electrode 7 and the sheathing layer 9 with respect to the radial direction of the cable-shaped piezoelectric element 1. This leaf spring 13 constitutes the shape-retaining member for retaining the cable-shaped piezoelectric element 1 in a predetermined shape, and yields the same advantage as that yielded by the coil spring 11.

For example, leaf springs provided below can be used as a material for the leaf spring 13. However, the material is not limited to these leaf springs.
SK5 (a common leaf spring);
SUS301-CSP3/4H, SUS304-CSP3/4H (stainless steel)

Fig. 3 shows another modification of the cable-shaped piezoelectric element 1. In this modification, an independent shape-retaining member, such as the coil spring 11 shown in Fig. 1 and the leaf spring 13 shown in Fig. 2, is not provided. Instead of these shape-retaining members, a core electrode 3a and/or a sheathing layer 9a, which have a shape-retaining characteristic, are used. The core electrode 3a and/or the sheathing layer 9a yield the same advantages as those yielded by the coil spring 11 and the leaf spring 13.

Especially, in the case of a simple member such as the leaf spring 13, deformation resulting from application of a stress and deformation arising when the member restores a retained shape become constant to a certain extent. Hence, a stable output is obtained. Moreover, so long as the shape has been restored by the next application of a stress, an output having reproducibility is obtained.

Even in the present embodiment, the core electrode 3a can be formed from, e.g., a shape memory alloy. A shape memory alloy is an alloy which restores its original shape even when deformed, so long as the alloy is heated to a certain temperature or higher. The shape is restored when a low-temperature crystal structure is replaced with a high-temperature crystal structure as a result of an increase in the temperature of the alloy. The temperature where the crystal structure is replaced (a transformation point) usually ranges from 20°C to 100°C. An alloy consisting of nickel and titanium can be used as a material for the alloy. However, no specific limitations are imposed on the type of metal.

In the present embodiment, the sheathing layer 9a can be formed from, e.g., a heat-shrinkable tube. Polyolefine or hard, shrinkable vinyl chloride can be used as a material for the heat-shrinkable tube. However, no limitations are imposed on the material.

Either of the core electrode 3a and the sheathing layer 9a may be imparted with a shape-retaining characteristic. Alternatively, both of them may be imparted with the shape-retaining characteristic.

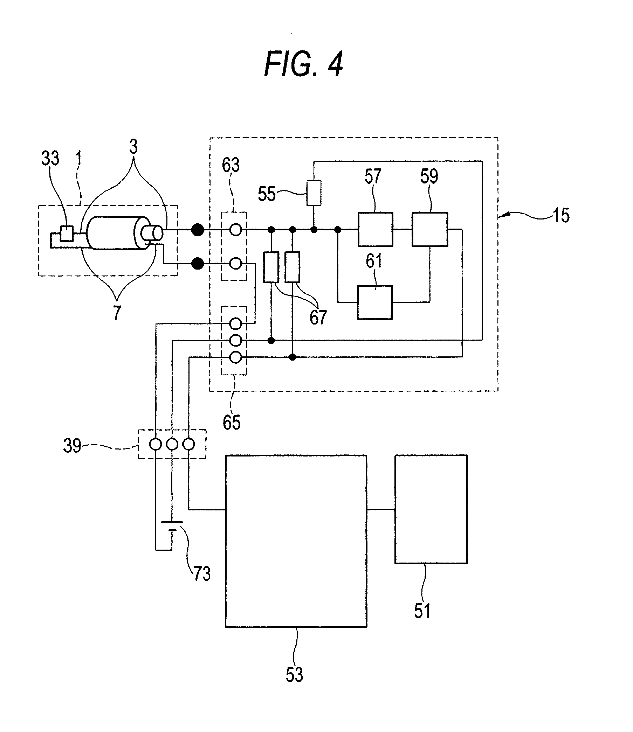

As shown in Fig. 4, a control circuit 15 for detecting the presence or absence of vibrations in the signal output from the cable-shaped piezoelectric element 1 is provided with a beeper 51 for informing the user of vibration and a beeper control section 53 for controlling operation of the beeper 51, thereby constituting the vibration detection sensor system. The control circuit 15 is generally formed from patterning on the substrate 2 shown in Fig. 4.

The control circuit 15 comprises a voltage-dividing resistor 55 used for detecting a breakage in the wire of the cable-shaped piezoelectric element 1; a filtering section 57 which permits passage of only a predetermined frequency component of the signal output from the cable-shaped piezoelectric element 1; a determination section 59 for determining occurrence of contact of the article with the cable-shapedpiezoelectric element 1 in accordance with a signal output from the filtering section 57; and an anomaly determination section 61 for determining occurrence of an anomalous breakage in the wire of the core electrode 3 or the outer electrode 7, both of which belong to the cable-shaped piezoelectric element 1, from a voltage value determined by a resistor 33 for detecting a line breakage and the voltage-dividing resistor 55. A signal input section 63, which connects the core electrode 3 and the outer electrode 7 to the control circuit 15 and inputs the signal output from the cable-shaped piezoelectric element 1 to the control circuit 15, and a signal output section 65 for outputting the determination signal generated by the determination section 59 are provided within the control circuit 15 while being adjacent to each other. The signal output section 65 is also connected to a power line for the control circuit 15, as well as to a ground line. Moreover, the control circuit 15 has bypass sections 67, such as a Capacitor or the like, which are interposed between the signal input section 63 and the signal output section 65 and bypass a high-frequency signal. Further, the signal output section 65 is provided with a power source 73 for supplying power to the cable-shaped piezoelectric element via the control circuit 15. The beeper control section 53 and the power source 73 are connected to the signal output section 65 of the control circuit 15 by means of a connector 39.

In order to eliminate external electrical noise, the entirety of the control circuit 15 is covered with the shield member and, thus, is electrically shielded. The outer electrode 7 remains in electrical conduction with the shielding member of the control circuit 15, and the cable-shaped piezoelectric element 1 is also electrically shielded. The input-and-output sections of the circuit may also be additionally equipped with a feed-through capacitor, an EMI filter, or the like, as a countermeasure against an intense electric field.

A common printed board, or the like, can be used for the substrate 2, and no specific limitations are imposed on the substrate 2. Moreover, no specific limitations are imposed on a method for connecting the substrate 2 to the cable-shaped piezoelectric element 1. Various general-purpose printed boards or the like can be used for the substrate 2.

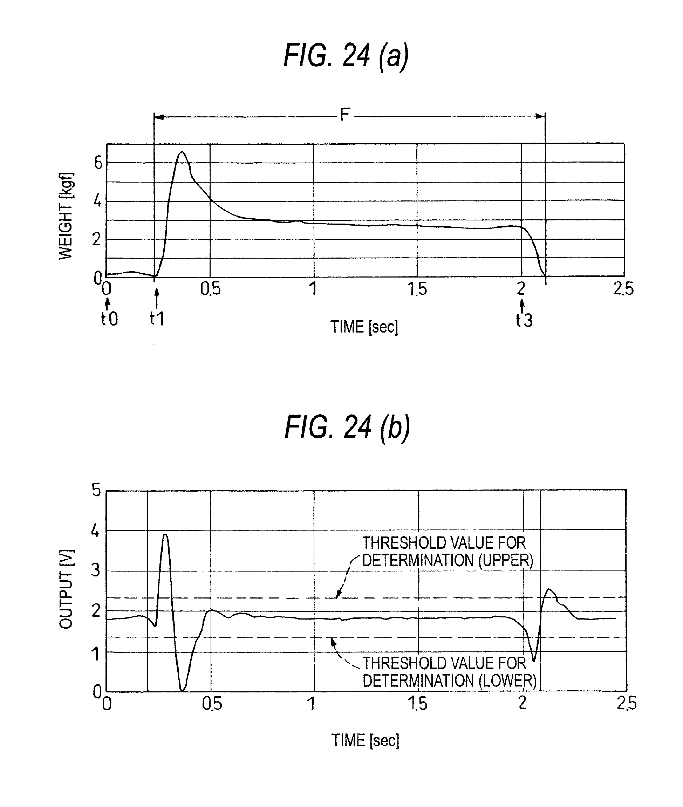

Figs. 24(a) and 24(b) are charts showing loads imposed on the cable-shaped piezoelectric element 1 and an output from the sensor. Tests on a relationship between the load on the cable-shaped piezoelectric element 1 and an output from the sensor (hereinafter called a "sensor output") having been conducted by the present applicant show the phenomenon of, when bending load, such as that shown in Fig. 24(a), is imposed on the cable-shaped piezoelectric element 1, an output from the sensor exhibits a waveform as shown in Fig. 24(b).

(1) Specifically, when no load was imposed on the cable-shaped piezoelectric element 1 at time t0, the sensor output exhibited 2(V). (2) When bending load was exerted on the cable-shaped piezoelectric element 1 in a given direction at time t1, the sensor output was increased to 4(V) but immediately inverted to 0(V), and again returned to 2(V). (3) Subsequently, even when the cable-shaped piezoelectric element remained bent, the sensor output continued to exhibit 2(V). (4) When the cable-shaped piezoelectric element 1 was restored to its original shape at time t3, the sensor output was decreased to 0.8(V) at that moment but immediately inverted to 2.2(V), and again returned to 2(V).

When the cable-shaped piezoelectric element 1 was bent in a direction apposite the bending direction in Test (2) through 180 degrees under the same conditions during Test (2), the sensor output was decreased to 0 (V) but immediately inverted to 4 (V), and again returned to 2(V).

When the cable-shaped piezoelectric element 1 was bent quickly during Test (2) under the same conditions, the sensor output became larger than that exhibited in Test (2). When the cable-shaped piezoelectric element 1 was bent slowly, the sensor output became smaller.

The same result was yielded even when the cable-shaped piezoelectric element 1 was bent in a direction opposite the above bending direction through 180 degrees. Specifically, when the cable-shaped piezoelectric element 1 was bent quickly, a great fluctuation appeared. When the cable-shaped piezoelectric element 1 was bent slowly, a small fluctuation appeared. From these results, the longitudinal bending direction of a single cable-shaped piezoelectric element 1 and an acceleration of bending action are ascertained. Accordingly, an analog input device can be obtained by use of the cable-shaped piezoelectric element 1.

### (Second Embodiment)

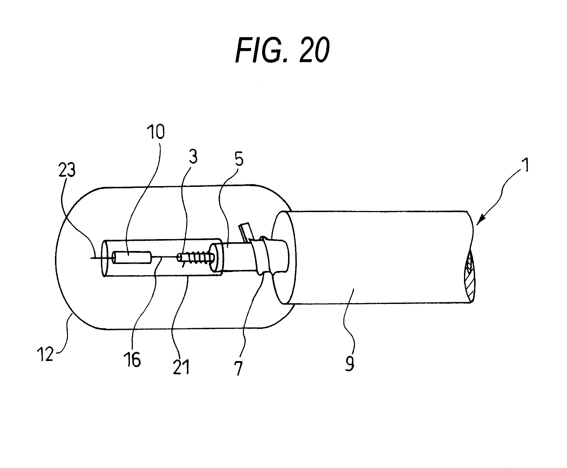

In addition to having the configuration shown in Fig. 5, a vibration detection sensor 110 of the present embodiment shown in Fig. 6 is provided with a weight 4 which is fixed at the uppermost end portion of the cable-shaped piezoelectric element 1. By means of this configuration, sensitivity of the vibration detection sensor 110 to the vibration of the cable-shaped piezoelectric element 1 can be enhanced. The weight 4 can be formed from, e.g., an arbitrary resin material, and can be thermally fastened to the cable-shaped piezoelectric element 1. The cable-shaped piezoelectric element 1 is generally subjected to predetermined end processing. The end processing may be achieved by means of sealing a line breakage detection resistor (corresponding to the line breakage detection resistor 33 shown in Fig. 4) with predetermined mold resin. Fig. 20 shows an example of such end processing. A predetermined resistor 10 is connected to the core electrode 3a by means of a wire 16, and the core electrode 3 and the resistor 10 are sheathed by another thermally shrinkable tube 21. An end section 23 of the wire 16 is exposed from the thermally shrinkable tube 21. Further, the end section, in particular, an area from the periphery of the thermally shrinkable tube 21 to the cable, is sealed by mold resin 12. The mold resin 12 is formed from a conductive resin material, and plays a role in bringing the end section 23 of the wire 16 into electrical contact with the outer electrode 7. If the mold resin 12 does not have any conductivity, the end section 23 of the wire 16 may be brought into electrical conduction with the outer electrode 7 while the periphery of the thermally shrinkable tube 21 is sheathed with a conductive tape.

### (Third Embodiment)

In a vibration detection sensor 120 of the present embodiment shown in Fig. 7, the entirety of the cable-shaped piezoelectric element 1 is bent into substantially U-shape, and both ends of the cable-shaped piezoelectric element 1 are fixedly connected to the substrate 2. A bend is provided in at least one point in the cable-shaped piezoelectric element 1. At the bend, predetermined tensile force remains exerted on the piezoelectric member, whereby vibration detection sensitivity of the vibration detection sensor 120 is enhanced. Moreover, by means of formation of the bend, the length of the piezoelectric member can be ensured in a space-saving manner. The longer the piezoelectric member, the greater the amount of distortion of the entire piezoelectric member caused by detection of vibrations. The amount of electromotive force is accordingly increased, and a signal output is improved. In the present embodiment, the bend assumes substantially U-shape; namely, a curved shape, and encompasses the concept of a "flexion" which will be described later.

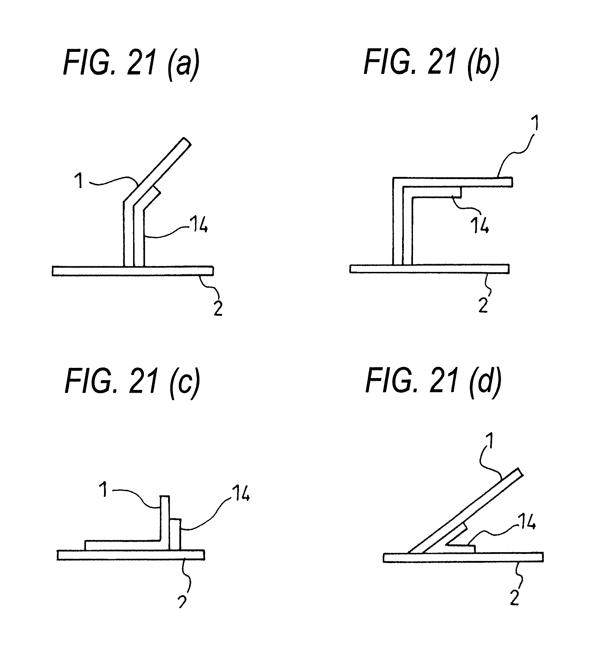

Fig. 21 shows various examples where the cable-shaped piezoelectric element 1 having a flexural portion, serving as a bend, is provided on the substrate 2. In the illustrated embodiment, a holder 14 is brought into intimate contact with the cable-shaped piezoelectric element 1 and mounted on the substrate 2 while supporting the cable-shaped piezoelectric element. This holder 14 contributes toward retaining the shape of the cable-shaped piezoelectric element 1, and maintains the piezoelectric element 1 extended from the substrate 2. In this case, it is not always necessary to impart a shape-retaining characteristic to the cable-shaped piezoelectric element 1.

In the embodiment shown in Figs. 21(a) and 21(b), the cable-shaped piezoelectric element 1 and the holder 14 are respectively provided with mutually-corresponding flexural portions. In Fig. 21(a), the flexural portions assume an obtuse angle. In Fig. 21(b), the flexural portions assume a right angle. In an embodiment shown in Fig. 21(c), the holder 14 is not provided with the flexural portion, and the cable-shaped piezoelectric element 1 is bent at right angles. In an embodiment shown in Fig. 21(d), the cable-shaped piezoelectric element 1 is not provided with the flexural portion, and the holder 14 is bent. The cable-shaped piezoelectric element 1 is retained on the substrate 2 at a predetermined angle corresponding to the angle of the flexion.

The related-art piezoelectric element, whichdiffers from the piezoelectric elements such as those shown in Figs. 1 through 3, does not have any shape-retaining characteristic and itself has elasticity. Accordingly, the element retains the property of still attempting to restore the original shape (a residual shape restoration characteristic) even when the element is fixed while being deformed in a desired shape. Therefore, when predetermined force has been applied to the element from the outside, an output derived from the shape restoration characteristic as well as an output (a correct output) originating from deformation caused by application of force can also arise. The output originating from the shape restoration characteristic assumes various values according to a deformed shape or a fixing method, and hence there exists a problem of an unstable output of the fixedly-placed element.

After having been processed once into a predetermined shape, the coil spring 11 of the cable-shaped piezoelectric element 1 of the present embodiment has the shape-retaining characteristic for retaining its shape. Accordingly, this results in the cable-shaped piezoelectric element 1 itself possessing the shape-retaining characteristic. Even when the cable-shaped piezoelectric element 1 has been deformed into substantially U-shape as shown in Fig. 7, the property of still attempting to restore its original shape (the residual shape restoration characteristic) becomes substantially zero. Consequently, when predetermined force has been applied to the element from the outside, an output induced by the shape restoration characteristic is zero or becomes substantially zero. Put another way, a correct output induced by only applied force can be obtained stably. Here, the term "substantially zero" signifies that an output induced by the remaining shape restoration characteristic is nominal to such an extent that a correct output is obtained without entailment of a practical problem.

### (Fourth Embodiment)

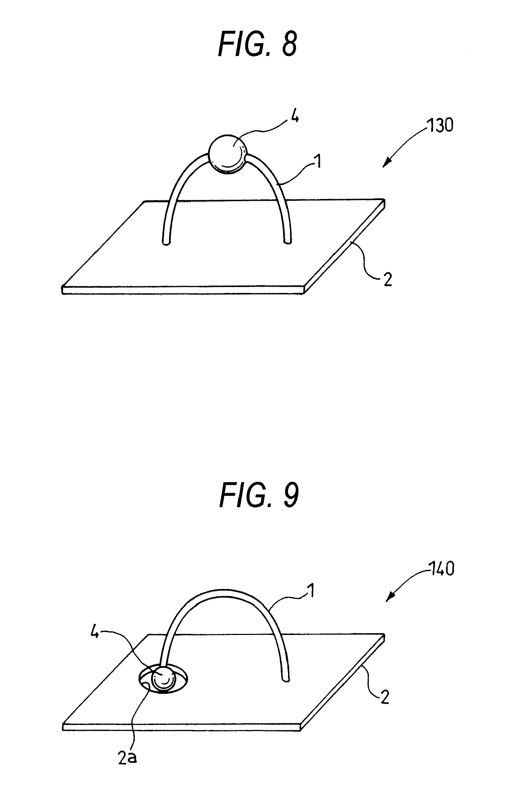

In addition to having the configuration shown in Fig. 7, a vibration detection sensor 130 of the present embodiment shown in Fig. 8 has the weight 4 which is fastened to a bend of the cable-shaped piezoelectric element 1; particularly, to the top of the bend. By means of this configuration, the sensitivity of the cable-shaped piezoelectric element 1 to vibration can be enhanced.

### (Fifth Embodiment)

In a vibration detection sensor system 140 of an embodiment shown in Fig. 9, the weight 4 is fastened to an open end of the U-shaped cable-like piezoelectric element 1, which is opposite the end thereof fastened to the substrate 2. The curvature of the entire cable-shaped piezoelectric element 1 and the position of a through hole 2a are adjusted such that the weight 4 vibrates within the through hole 2a, which is formed so as to penetrate through the substrate 2, in association with deformation of the cable-shaped piezoelectric element 1 during application of vibration. By means of this configuration, the sensitivity of the cable-shaped piezoelectric element 1 to vibration can be enhanced.

### (Sixth Embodiment)

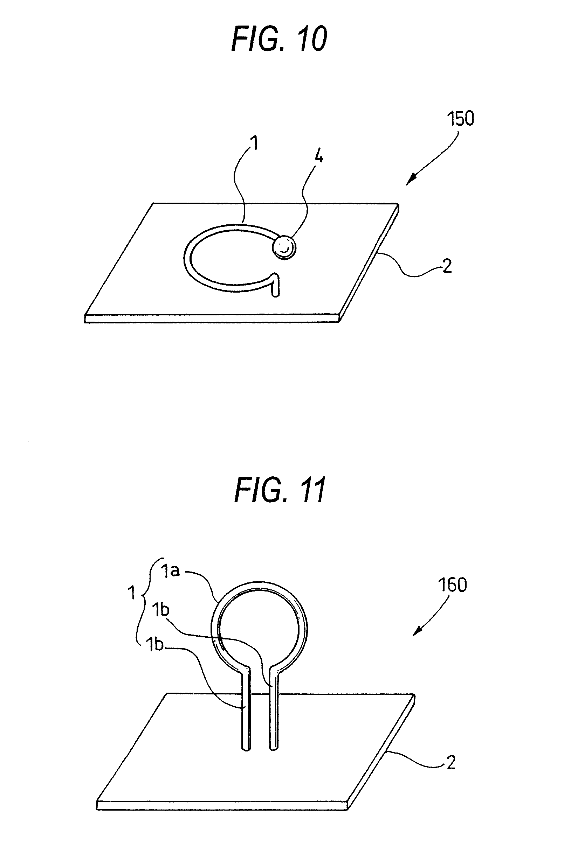

In a vibration detection sensor 150 of an embodiment shown in Fig. 10, the weight 4 is fastened to an open end of the cable-like piezoelectric element 1, which is opposite the end thereof fastened to the substrate 2. The cable-shaped piezoelectric element 1 is bent into a substantially circular pattern within a plane substantially parallel to the principal surface of the substrate 2. Even in this configuration, the sensitivity of the cable-shaped piezoelectric element 1 to vibration can be enhanced.

### (Seventh Embodiment)

In a vibration detection sensor 160 of an embodiment shown in Fig. 11, the cable-shaped piezoelectric element 1 comprises: 1) end sections 1b, 1b which are fastened to the substrate 2 and are arranged so as to become substantially parallel to each other; and 2) a center circular section 1a which is located between the both end sections 1b and formed in a substantially circular pattern.

### (Eighth Embodiment)

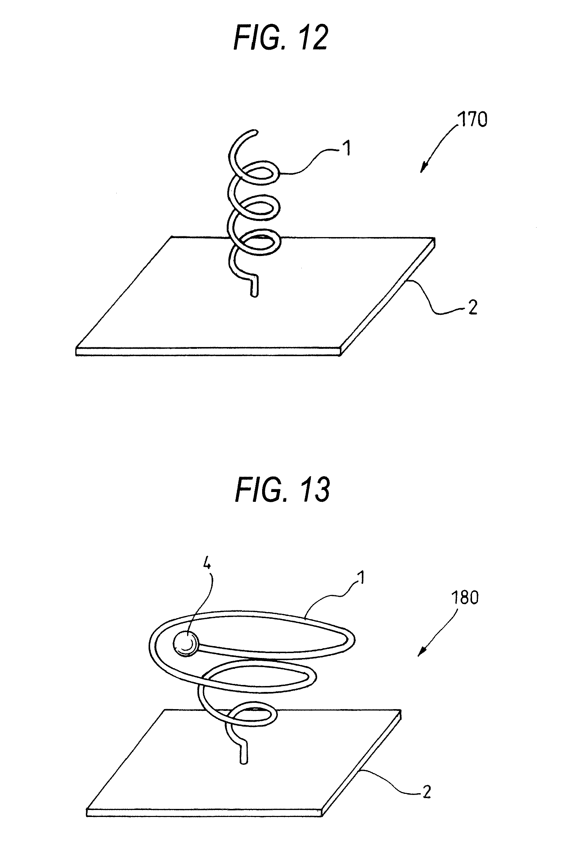

In a vibration detection sensor 170 of a present embodiment shown in Fig. 12, the cable-shaped piezoelectric element 1 is formed into the shape of a coil and provided substantially upright on the substrate 2. By means of this configuration, the sensitivity of the cable-shaped piezoelectric element 1 to vibration can be enhanced.

### (Ninth Embodiment)

In a vibration detection sensor 180 of a present embodiment shown in Fig. 13, the cable-shaped piezoelectric element 1 is formed into the shape of a coil, and the diameter of the coil is increased with increasing distance from the substrate 2. The weight 4 is fastened to an open end of the cable-like piezoelectric element 1, which is opposite the end thereof fastened to the substrate 2. Even in the case of this configuration, the sensitivity of the cable-shaped piezoelectric element 1 to vibration can be enhanced.

### (Tenth Embodiment)

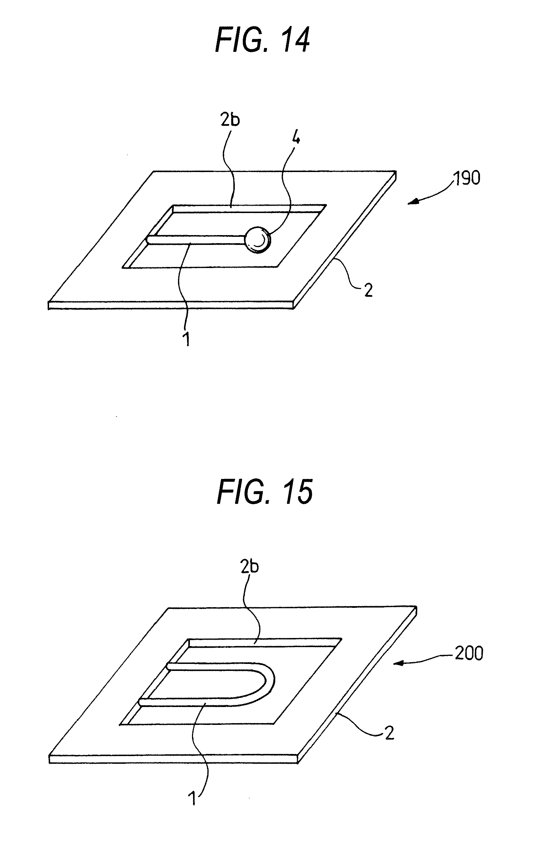

In a vibration detection sensor 190 of a present embodiment shown in Fig. 14, a substantially rectangular through hole 2b is formed in the substrate 2, and the cable-shaped piezoelectric element 1 is fastened to the substrate 2 so as to be able to vibrate within the through hole 2b. The cable-shaped piezoelectric element 1 is provided in an extending manner within the through hole 2b so as to become substantially parallel to the principal surface of the substrate 2. The weight 4 is fastened to an open end of the cable-like piezoelectric element 1, which is opposite the end thereof fastened to the substrate 2. Even in the case of this configuration, the sensitivity of the cable-shaped piezoelectric element 1 to vibration can be enhanced.

### (Eleventh Embodiment)

As in the case of the embodiment shown in Fig. 14, the substantially rectangular through hole 2b is formed in the substrate 2 in a vibration detection sensor 200 of a present embodiment shown in Fig. 15, and the cable-shaped piezoelectric element 1 is fastened to the substrate 2 so as to be able to vibrate within the through hole 2b. The cable-shaped piezoelectric element 1 is provided in an extendingmanner within the through hole 2b so as to become substantially parallel to the principal surface of the substrate 2. The cable-shaped piezoelectric element 1 is bent into a substantially U-shaped form, and both ends of the cable-shaped piezoelectric element 1 are fastened to the substrate 2.

### (Twelfth Embodiment)

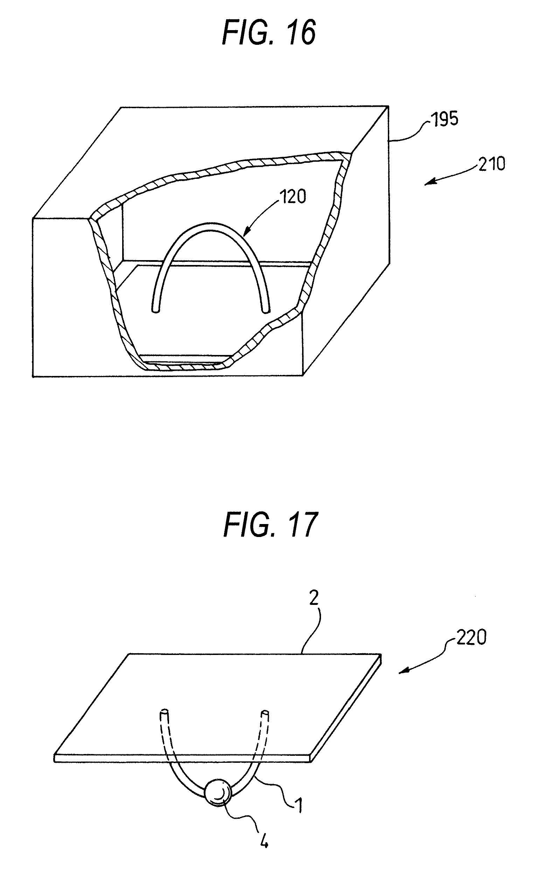

A vibration detection sensor 210 of a present embodiment shown in Fig. 16 is formed by means of housing the vibration detection sensor 120 shown in Fig. 7 in an enclosure 195. Since the cable-shaped piezoelectric element 1 is deformable, the enclosure 195 may also be a compact enclosure. By means of attaching the piezoelectric element 1 to walls of the enclosure in each of the three-dimensional axes thereof, vibration in the respective three-dimensional directions can be detected more rigorously. Further, noise in the sensor can be canceled by means of forming the enclosure from a shield case. All of the other vibration detection sensors can be disposed within the enclosure, as well.

### (Thirteenth Embodiment)

In a vibration detection sensor 220 according to the present embodiment shown in Fig. 17, the cable-shaped piezoelectric element 1 shown in Fig. 8 is downwardly suspended from the substrate 2 and fastened thereto. Consequently, the vibration detection sensor assumes a shape formed by inverting the vibration detection sensor 130 shown in Fig. 8. The other vibration detection sensors can also be used in an inverted state.

### (Applications)

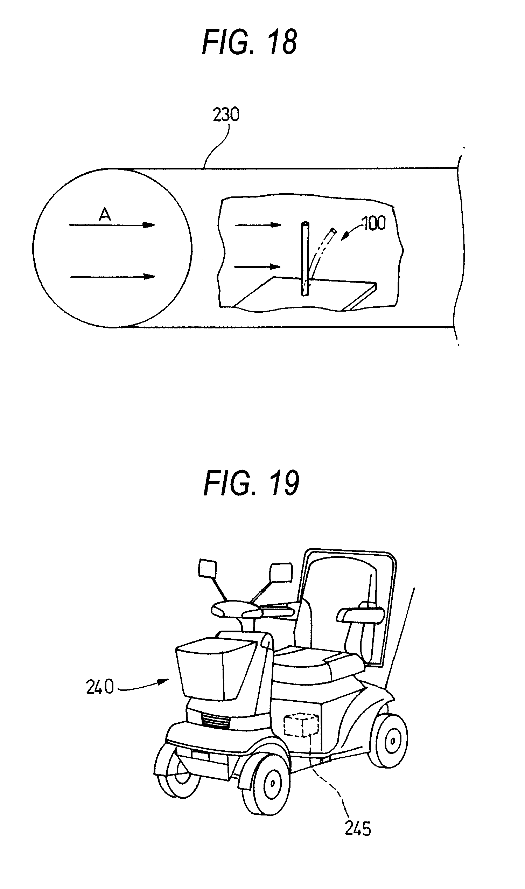

Fig. 18 shows the example vibration detection sensor of the present invention applied to a flow-rate-measuring instrument. In the present embodiment, the vibration detection sensor 100 shown in Fig. 5 is disposed in a flow channel 230. A flow A of a medium such as water collides with the cable-shaped piezoelectric element 1, and a flow rate can be measured on the basis of the degree of collision.

Fig. 19 shows the example vibration detection sensor of the present invention applied to a motor-driven buggy. In the present embodiment, any one of the above-described vibration detection sensors is provided within a space 245 toward the bottom of a motor-driven buggy 240. The vibration detection sensor detects vibration arising when a driver touches the motor-driven buggy 240 and gets on the car, to thus activate or deactivate the main power of the motor-driven buggy 240.

In synchronization with vibration arising during driving operation, there may be effected control so as to activate or deactivate various lighting fixtures of the buggy, such as headlamps of a vehicle body or a driving monitor. Thereby, consumption of a battery is reduced, to thus achieve power saving, and the driver can also be prevented from forgetting about turning off the lighting fixtures. Even when vibration is not detected, the vibration detection sensor is held in an activated state for a predetermined period of time (e.g., during a period of suspension or the like) or in a standby condition. As a result, even in the case of suspension, the vibration detection sensor can immediately detect vibration even when the car resumes driving.

There may also be adopted a configuration for detecting vibration which arises when the human body attempts to get on the buggy; e.g., vibration which arises when the driver touches the handle or sits on a seat, or the like, thereby illuminating various lighting fixtures. Further enhanced convenience can also be attained.

The flow rate measuring instrument and the motor-driven buggy, which have been described above, are mere illustrations of applications. Needless to say, the vibration detection sensor of the present invention can be applied to other products for detecting vibration, pressure, and stress as well as to an motor-driven buggy.

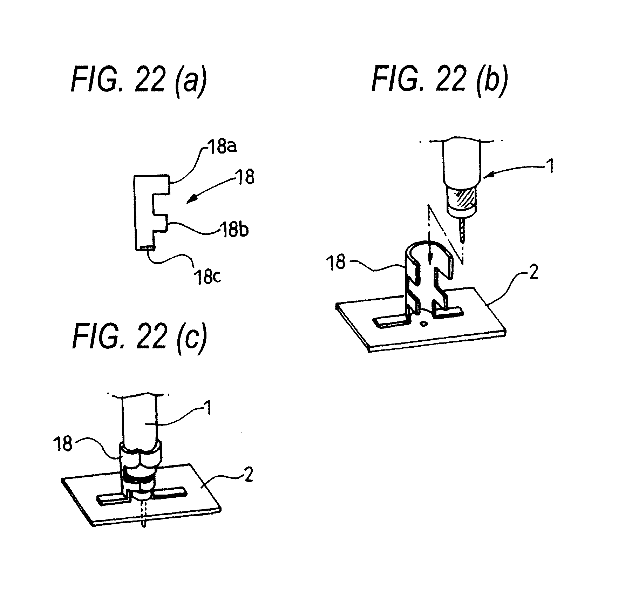

Fig. 22 shows an example method for mounting the cable-shaped piezoelectric element 1 to the substrate 2. As shown in Fig. 22(a), a metal fixture 18 comprises an upper caulking section 18a, a lower caulking section 18b, and a bottom section 18c. As shown in Fig. 22 (b), the metal fixture 18 is disposed on the substrate 2 via the bottom section 18c. As shown in Fig. 22(c), the sheathing layer 9 is caulked by the upper caulking section 18a, and the outer electrode 7 is caulked by the lower caulking section 18b. Thus, the cable-shaped piezoelectric element 1 is fastened onto the substrate 2.

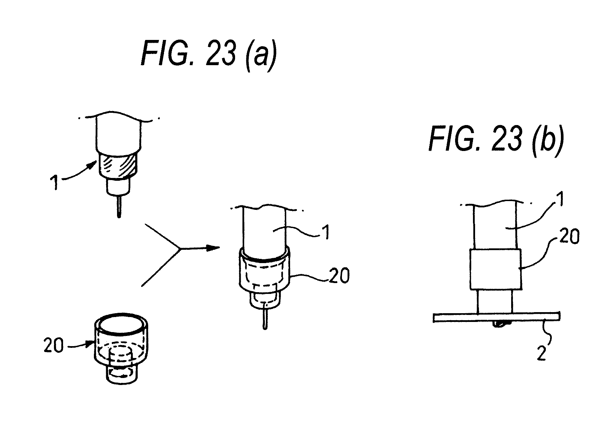

Fig. 23 shows another example method for fastening the cable-shaped piezoelectric element 1 to the substrate 2. As shown in Fig. 23(a), an antenna attachment connector 20 is attached to the extremity of the cable-shaped piezoelectric element 1. As shown in Fig. 22(b), the cable-shaped piezoelectric element 1 is fastened onto the substrate 2. Specifically, a common connector, which is used as a component for attaching an antenna, can also be employed. When the antenna attachment connector 20 is formed from metal, the connector contacts the outer electrode 7 but does not contact the core electrode 3.

The vibration detection sensor of the present invention adopts a predetermined cable-shaped piezoelectric element which can adopt various shapes. Accordingly, there is provided a vibration detection sensor which can also be miniaturized while ensuring a high degree of detection of vibration and a high degree of freedom of design. This vibration detection sensor can provide a mounting method which is not subjected to limitations, such as a mount direction, a mount location, a mount space, and the like, and which ensures a high degree of freedom of attachment. An increase in the degree of design freedom of equipment using a sensor is also achieved. Moreover, the vibration detection sensor of the present invention enables detection with a high degree of attachment accuracy without previously specifying a vibrating direction and in an arbitrary mounted state.

### (Fourteenth Embodiment)

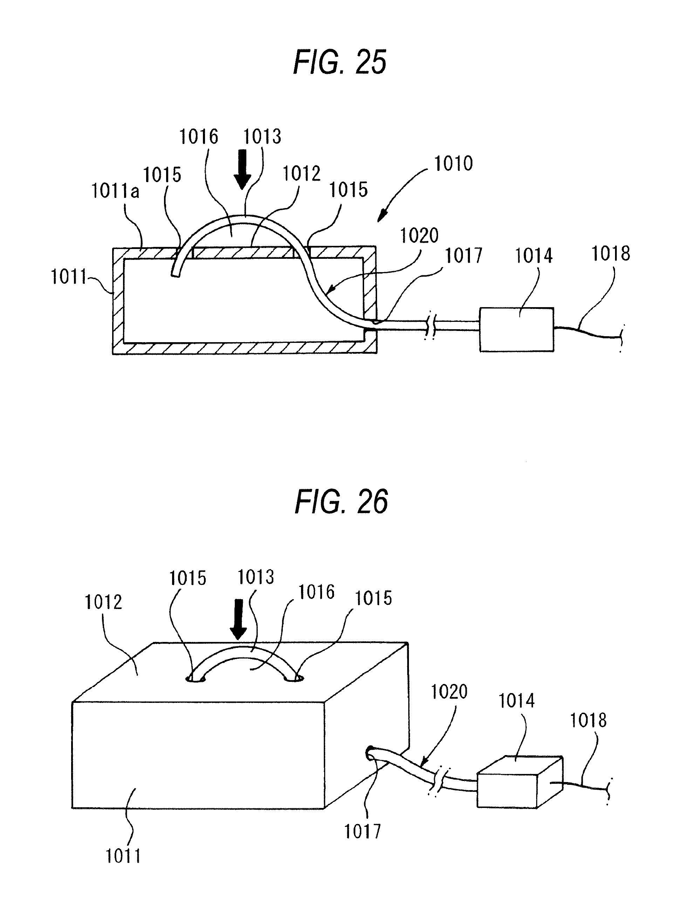

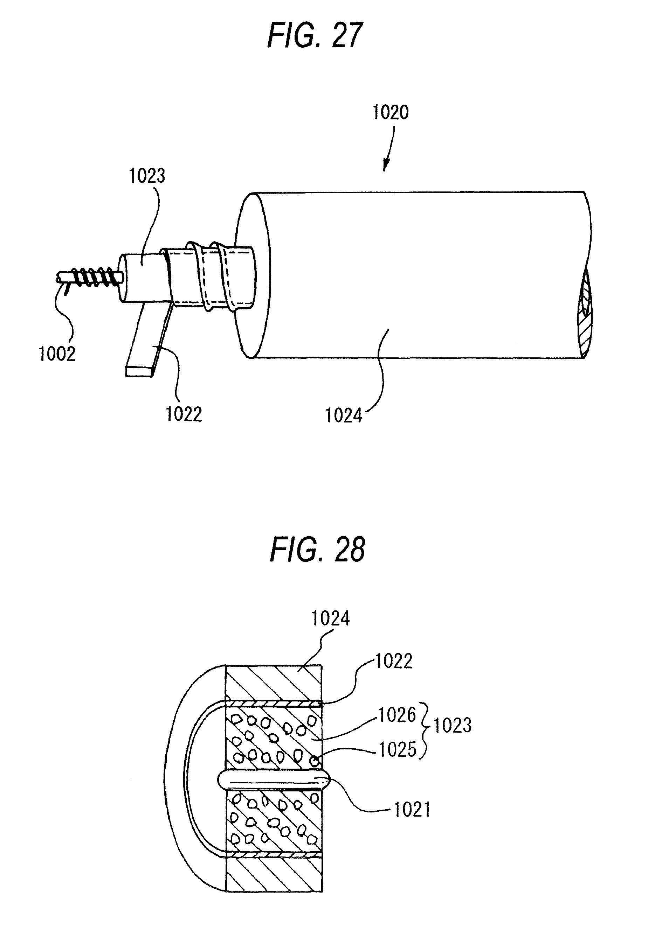

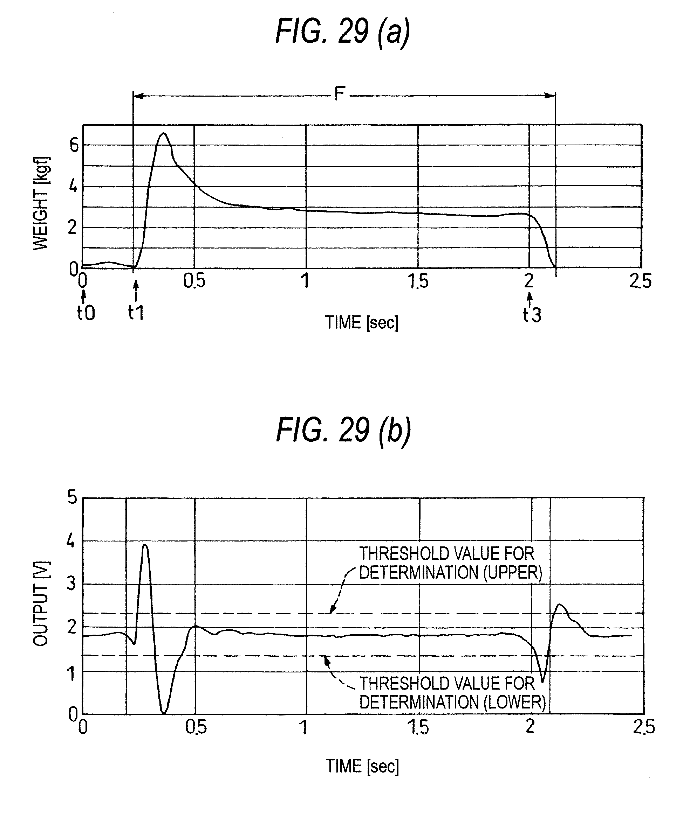

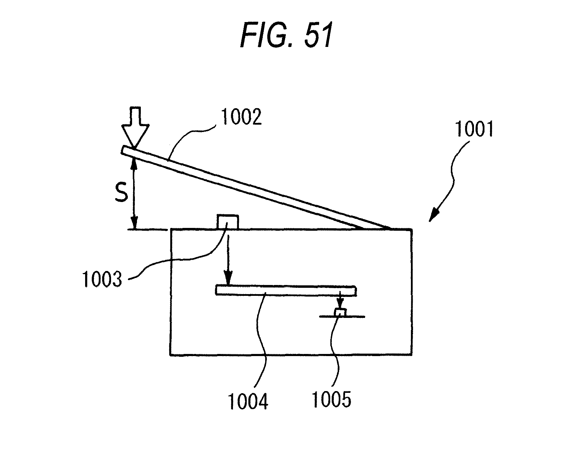

A fourteenth embodiment of the present invention will be described in detail by reference to the drawings. Fig. 25 is a cross-sectional view showing a pressure-sensitive switch which is a fourteenth embodiment of the present invention; Fig. 26 is a perspective view of the pressure-sensitive switch shown in Fig. 25; Fig. 27 is a perspective view for describing a piezoelectric cable; Fig. 28 is a cross-sectional perspective view for describing the structure of a piezoelectric element; and Figs. 29 to 237 show pressure-sensitive switches of other embodiments of the present invention.

First, a piezoelectric cable used for a pressure-sensitive switch which is a fourteenth embodiment of the present invention will be described by reference to Figs. 27 and 28.
As shown in Fig. 27, a piezoelectric cable 1020 comprises a core line 1021 which serves as a center electrode and is covered with a piezoelectric element material 1023. An outer electrode 1022 is coiled around the piezoelectric element material 1023. The outer electrode 1022 is covered with an outer sheath 1024 formed from a thermoplastic resin PVC (polyvinyl chloride) or the like. The piezoelectric cable 1020 has superior flexibility and generates an output signal in response to the acceleration of deformation obtained during deformation.

The core line 1021 is formed into a coiled metal center electrode which is formed from a copper-silver alloy or the like. As shown in Fig. 28, the piezoelectric element material 1023 is formed as a composite member consisting of a resin-based material 1026 and piezoelectric ceramic fine particles 1025 of 10 µm or less. The vibration detection characteristic is embodied by the piezoelectric ceramic fine particles 1025, and the flexible deformation characteristic is embodied by the resin-based material 1026.

For example,chlorine-based polyethylene can bementioned as the resin-based material 1026 of the piezoelectric element material 1023. Thereby, the piezoelectric element material 1023 can be used in a temperature range (120°C or less) higher than 90°C that is the maximum operating temperature of a related-art typical polymeric piezoelectric element material (uniaxially-stretched polyvinylidene fluoride) or a piezoelectric element material (a piezoelectric element material formed from chloroprene and piezoelectric ceramic fine particles). Further, flexibility which enables easy formation is realized, and simple manufacturing processes which do not require a crosslinkage is enabled.

For instance, sintered fine particles of lead titanate orlead-zirconate-titanate,or nonleaded piezoelectric ceramic sintered fine particles such as sodium niobate or the like, can be mentioned as the piezoelectric ceramic fine particles 1025 of the piezoelectric element material 1023.

A film-shaped electrode (a three-layer laminate film consisting of aluminum, polyethylene terephthalate, aluminum) is used for the outer electrode 1022. Thereby, adhesion between the piezoelectric element material 1023 and the outer electrode 1022 is ensured.

The thus-obtained piezoelectric cable 1020 is set so as to exhibit a dielectric constant of 55, an electric charge of 10 to 13C (coulomb)/gf, and a maximum operating temperature of 120°C. However, in a state where the piezoelectric element material 1023 remains formed, piezoelectric performance is not acquired. Hence, processing (polarization processing) for imparting piezoelectric performance to the piezoelectric element material 1023 must be performed by application of a high DC voltage of kilovolts/mm to the piezoelectric element material 1023.

When minute imperfections, such as cracks, are present in the piezoelectric element material 1023, an electric discharge arises in the imperfections, thereby rendering the electrodes prone to a short circuit. Hence, application of a sufficient polarization voltage becomes impossible. However, in the present embodiment, polarization processes using an auxiliary electrode which can intimately contact the piezoelectric element material 1023 of given length are established, thereby detecting or circumventing imperfections and rendering polarization. Thus, realization of a long piezoelectric element material of the order of tens of meters or more is made feasible.

As shown in Figs. 25 and 26, a pressure-sensitive switch 1010, which is a fourteenth embodiment of the present invention, comprises the piezoelectric cable 1020. At least a portion of the piezoelectric cable 1020 is caused to protrude from an upper supporting face 1012 of a rectangular parallelepiped sensor box 1011. The thus-protruding portion is bent into a bend section 1013, and a control circuit 1014 is connected to a base end portion of the piezoelectric cable 1020.
Thus, at least a portion of the piezoelectric cable 1020 protruding from the supporting face 1012 is bent, thereby rendering dense intervals among the piezoelectric ceramic fine particles 1025 on an inner circumference of the bend section 1013, and in turn facilitating generation of electromotive force.

Two cable insert holes 1015 are formed in a top plate 1011a of the sensor box 1011 while being separated from each other along the longitudinal direction (i.e., a lateral direction in Fig. 25) of the sensor box 1011. The piezoelectric cable 1020 is inserted into one cable insert hole 1015 from the inside of the sensor box 1011. The thus-inserted piezoelectric cable is bent at a single curvature and at an elevatedposition above the supporting face 1012 while retaining a clearance 1016 between the bend and the supporting face 1012, to thus form the bend section 1013. The leading end portion of the piezoelectric cable 1020 is inserted into the other cable insert hole 1015.
The leading end portion of the piezoelectric cable 1020 inserted into the other cable insert hole 1015 is fastened by fastening means, such as a bolt, an adhesive, a gel filled in the sensor box 1011, or the like.

The base end portion of the piezoelectric cable 1020 is inserted into a cable insert hole 1017 formed in a side of the sensor box 1011; led to the outside of the sensor box 1011; and connected to the control circuit 1014. The control circuit 1014 is connected to a cable 1018. The control circuit 1014 may amplify an analogue signal and output the thus-amplified signal, or may convert the amplified analog signal by means of an analog-to-digital conversion section and output a digital signal. Alternatively, a filtering section, or the like, may extract a predetermined frequency range from a digital signal, and output the thus-extracted frequency range.
The cable 1018 connected to the control circuit 1014 is for use in supplying power and outputting a detection signal. The cable 1018 is connected to a power source or a terminal, such as a computer, by way of a connector (not shown) attached to the extremity of the cable.

As a result of force, which deforms the bend section 1013 in, e.g., an arrowy direction in Figs. 25 and 26 or toward the supporting face 1012 of the sensor box 1011, being exerted on the piezoelectric cable 1020, the pressure-sensitive switch 10 such as that mentioned above produces an output signal in response to the acceleration of deformation achieved during deformation of the piezoelectric cable 1020.

Figs. 29(a) and 29(b) are charts showing loads imposed on the pressure-sensitive switch 1010 and characteristics of an output signal. As a result of the applicant having conducted a test on the relationship between the loads on the pressure-sensitive switch 1010 and an output signal, when bending load, such as that shown in Fig. 29(a), is imposed on the pressure-sensitive switch 1010, it is ascertained that an output signal exhibits a phenomenon such as that shown in Fig. 29(b). (1) Specifically, when no load was imposed on the pressure-sensitive switch 1010 at time t0, the output signal exhibited a voltage of 2(V).
(2) When a bending load was imposed on the pressure-sensitive switch 1010 at time t1 in a given direction, the output signal was increased to 4(V) at the instant of application of the load but immediately reversed to 0(V), and again returned to 2(V).
(3) Subsequently, even when the pressure-sensitive switch remained bent, the output signal kept exhibiting 2(V).
(4) When the pressure-sensitive switch 1010 was returned to the original state at time t3, the output signal was decreased to 0.8(V) at that moment but immediately inverted to 2.2(V), and again returned to 2(V).

When the pressure-sensitive switch was bent in a direction opposite the bending direction in Test (2) through 180 degrees under the same conditions employed during Test (2), the output signal was decreased to 0 (V) but immediately inverted to 4 (V), and again returned to 2(V).

When the pressure-sensitive switch was bent fast during Test (2) under the same conditions, the output signal became larger than that exhibited in Test (2). When the pressure-sensitive switch was bent slowly, the output signal became smaller.

The same result was yielded even when the pressure-sensitive switch was bent in a direction opposite the above bending direction. Specifically, when the pressure-sensitive switch was bent quickly, a great fluctuation appeared. When the pressure-sensitive switch was bent slowly, a small fluctuation appeared.

This signal is not an output having a rectangular waveform. When a load is imposed on the pressure-sensitive switch 1010, or when a load is removed, the signal is output as an analog signal having a waveform corresponding to the manner of application of load (a speed and a stroke) and the material of a location where the load is imposed.
Accordingly, inrelationtothepressure-sensitiveswitch 1010, the characteristic of the output signal can be readily adjusted by means of appropriately selecting the size, curvature, and material of the bend section 1013 according to applications.

As mentioned above, in the present embodiment, at least a portion of the piezoelectric cable 1020 protruding from the supporting face 1012 is bent. Accordingly, the pressure-sensitive switch assumes a structure where the amount of mechanical flexion of a piezoelectric material is increased. As a result of stress being applied to the bending section 1013, applied pushing pressure is detected with high sensitivity according to fluctuations in the intensity of and the stroke length of pushing pressure even when the pushing pressure is weak or the stroke of the pushing pressure is short, so that a signal corresponding to the acceleration of the pushing pressure can be output.

Particularly, the pressure-sensitive switch 1010 requires the minimum load stroke in order to deform the piezoelectric material. However, a signal is output even in response to minute deflection (displacement). A signal is output even in response to a stroke which is so extremely small that the user might erroneously believe that he/she had touched the switch.
Accordingly, this pressure-sensitive switch 1010 can be used just as a touch switch.

Since the control circuit 1014 amplifies an output signal, the pressure-sensitive switch 1010 can change switching sensitivity by means of making an alteration to the circuit configuration.
In addition, since the pressure-sensitive switch 1010 has no mechanical contact point, water resistance, durability, and reliability, which are higher than those achieved by the related-art microswitch, can be obtained.

Intervals among the grains of the piezoelectric ceramic fine particles 1025 located on the inner periphery of the bend section 1013 become denser, whereupon electromotive force becomes easy to arise. Thus, the piezoelectric cable 1020 can detect applied pushing pressure with high sensitivity and output a signal in response to the acceleration of the pushing pressure without regard to the fluctuations in pushing pressure and the length of a pushing stroke.

Further, the clearance 1016 is provided between the bend section 1013 and the supporting face 1012 of the piezoelectric cable 1020. Hence, the amount of distortion achieved when the piezoelectric cable 1020 is pushed can be increased, thereby ensuring a wide detection range.
Moreover, the bend section 1013 of the piezoelectric cable 1020 is curved at the single curvature, and hence sensitivity can be enhanced uniformly over the entire bend section 1013.

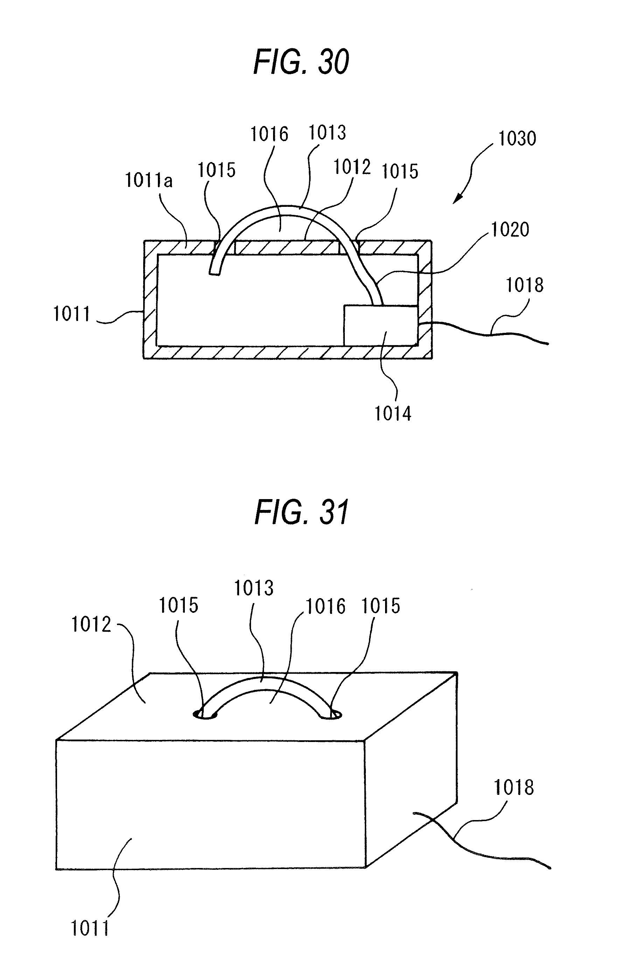

The pressure-sensitive switch of the present invention is not limited to the embodiment, and can be subjected to appropriate alterations, improvements, and the like.
For instance, the present embodiment has illustrated the pressure-sensitive switch 1010 where the control circuit 1014 is disposed outside the sensor box 1011. However, as shown in Figs. 30 and 31, there can also be embodied a pressure-sensitive switch 1030 in place of the pressure-sensitive switch 1010, wherein the control circuit 1014 is disposed in the sensor box 1011.

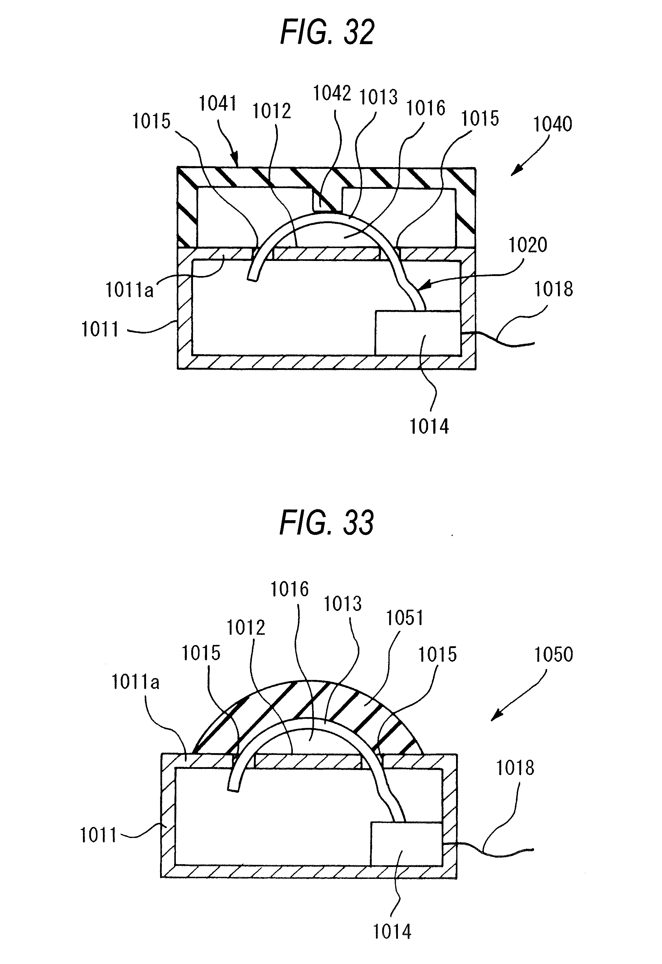

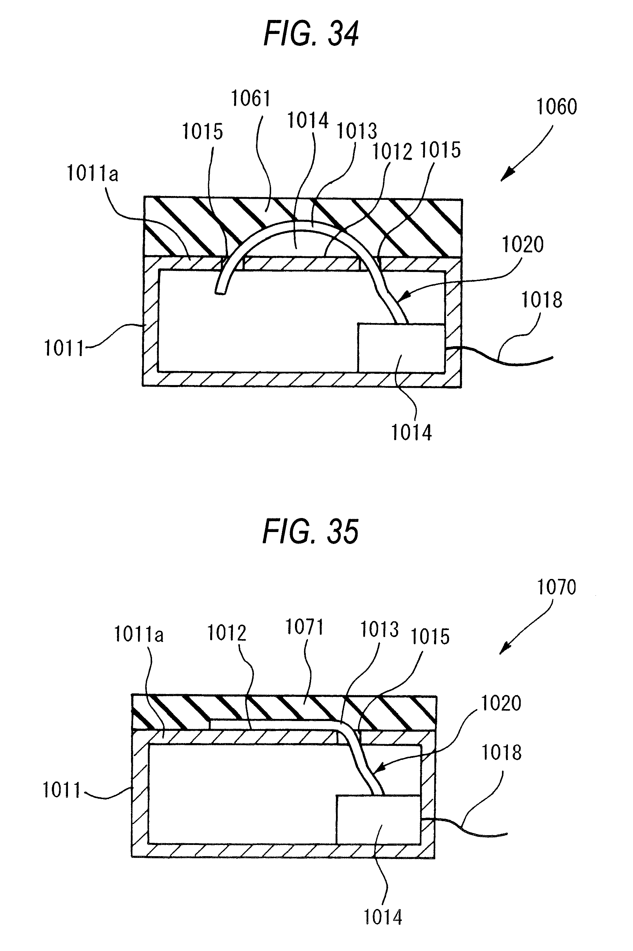

The above embodiment illustrates a case where the bend section 1013 of the piezoelectric cable 1020 protruding from the supporting face 1012 of the sensor box 1011 is exposed. As shown in Fig. 32, in place of this, there may also be embodied a pressure-sensitive switch 1040, wherein a cap section 1041 formed from an elastic material, such as rubber or the like, is placed on top of the sensor box 1011 and the top of the bend section 1013 can be pressed by a protruding section 1042 provided in the center of the interior surface of the cap section 1041. Moreover, as shown in Fig. 33, there may also be embodied a pressure sensitive switch 1050, wherein the bend section 1013 of the piezoelectric cable 1020 is covered with a coating material 1051, which is formed from an elastic material such as rubber or the like, in place of the cap section 1041 such that the bend section is covered in the form of a segment with the clearance 1016 being left. Further, as shown in Fig. 34, there may also be embodied a pressure-sensitive switch 1060, wherein the bend section 1013 of the piezoelectric cable 1020 is covered to a uniform thickness with a coating material 1061, which is formed from an elastic material, such as rubber or the like, such that the bend section is covered in a flat manner with the clearance 1016 being left.

Moreover, the present embodiment has illustrated the case where the clearance 1016 is provided between the supporting face 1012 of the sensor box 1011 and the bend section 1013. However, the present invention is not limited to the embodiment. For instance, as shown in Fig. 35, there may also be embodied a pressure-sensitive switch 1070, wherein the portion of the piezoelectric cable 1020 protrudes from the supporting face 1012 so long as the piezoelectric cable having the bend section 1013 is brought into contact with the supporting face 1012. In this embodiment, the bend section 1013 of the piezoelectric cable 1020 is covered with a coating material 1071, which is formed from an elastic material such as rubber or the like, in a flat manner.

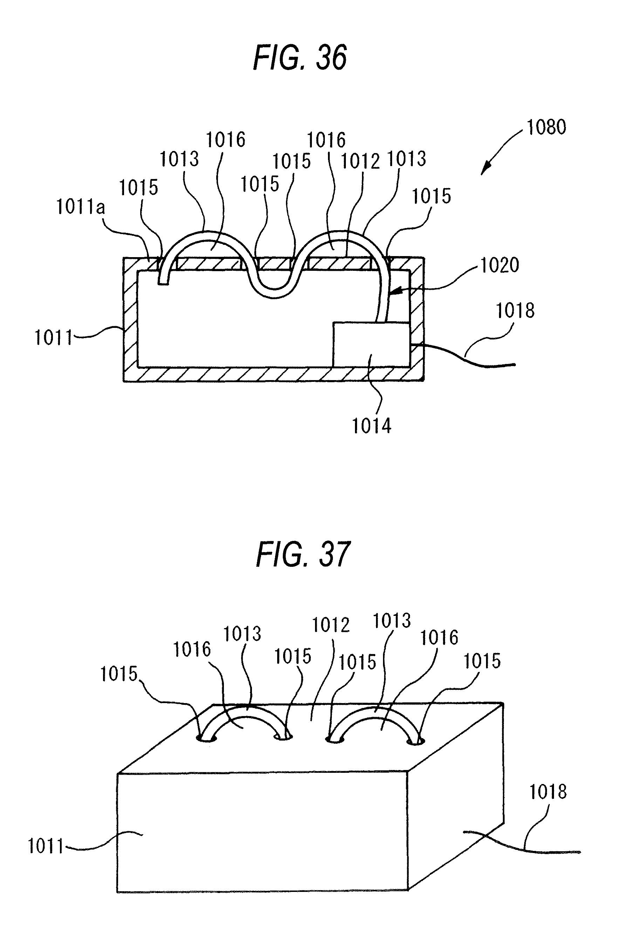

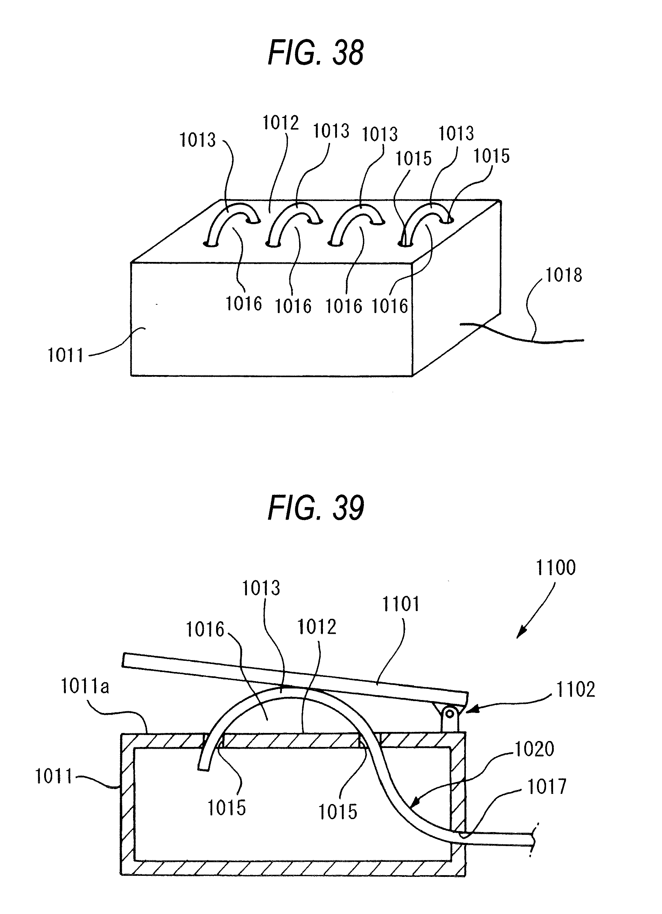

The present embodiment has illustrated the case where the bend section 1013 is projectingly formed at one point on the supporting face 1012 of the sensor box 1011. However, the present invention is not limited to this case. As shown in Figs. 36 and 37, there may also be embodied a pressure-sensitive switch 1080, wherein two or more bend sections 1013 (two in the illustration) are formed in the supporting face 1012 in a protruding manner by means of corrugating the piezoelectric cable 1020. Alternatively, as shown in Fig. 38, there may also be embodied a pressure-sensitive switch 1090, wherein the piezoelectric cable 1020 is bent and wound in a coiled manner to thus form the two or more bend sections 1013 (four in the drawing) so as to protrude from the supporting face 1012.

In the pressure-sensitive switch 1040 shown in Fig. 32, the cap section 1041 placed on top of the sensor box 1011 is formed from an elastic material such as rubber or the like. However, as in the case of a pressure-sensitive switch 1100 shown in Fig. 39, there may also be adopted a hard cap section 1101. One end of the cap section 1101 is joined to the upper portion of the sensor box 1011 by way of a hinge 1102. When no load is imposed on the cap section, the cap section 1041 is placed on the bend section 1013 under its own weight.
In pressure-sensitive switch 1100, the applied load is transmitted to the bend section 1013 by way of the cap section 1101 that pivots around the hinge 1102 with respect to the sensor box 1011, and the pressure-sensitive switch 1100 outputs a signal. When the applied load is released, the cap section 1101 is raised by means of elasticity which causes the bend section 1013 to attempt to return to the initial shape, thereby returning to the initial position.

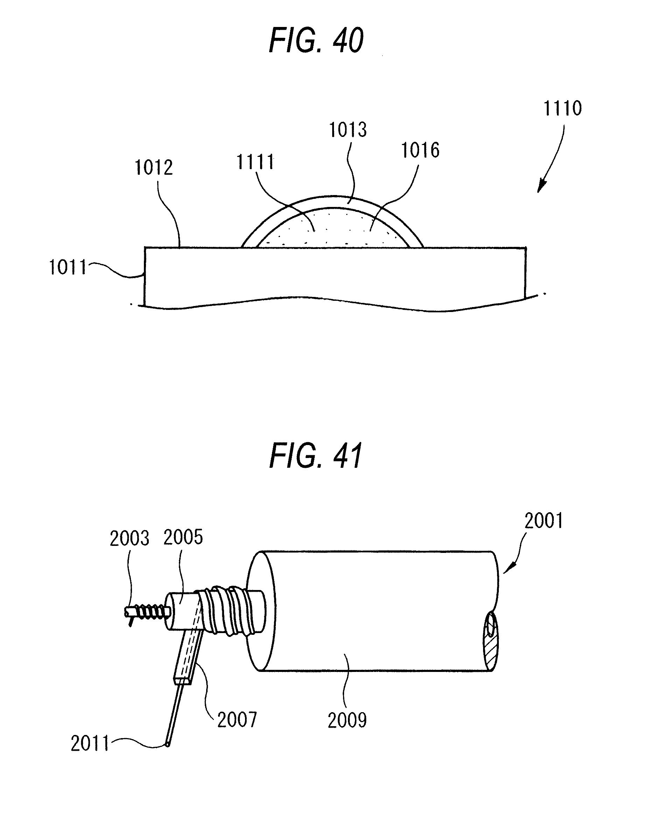

As in the case of a pressure-sensitive switch 1110 shown in Fig. 40, the space between the bend section 1013 and the supporting face 1012 of the sensor box 1011 may be filled with an elastic body 1111; e.g., a gel or the like.
The bent shape of the bend section 1013 can be maintained, and the bend section 1013 can be protected from excessive impact.

The manner of application of a load to the bend section 1013 is not only a direction toward the supporting face 1012 but also a radial direction from the bend center of the bend section 1013 or a direction (an inner, depthwise direction in Figs. 25 and 26) parallel to or crossing a curved axis. In short, the direction of load is arbitrary, so long as the piezoelectric cable 1020 can be deformed from the initial state thereof.

In other respects, the material, the shape, the dimensions, the mode, the number of, the locations, and the like, of the piezoelectric ceramic fine particles, the resin-basedmaterial, the structure of the piezoelectric element, the piezoelectric cable, the supporting face, thebendportion, the control circuit, the clearance, the fastening means, and the like, all of which have been illustrated in the foregoing embodiments, are arbitrary and not subjected to limitations, so long as the present invention can be attained.

### (Fifteenth Embodiment)

A fifteenth embodiment of the present invention will be described hereinbelow by reference to the drawings. In the descriptions of the embodiment, those elements which have the same configurations and yield the same working-effects as those described previously are assigned the same reference numerals, and their repeated explanations are omitted.

A cable-shaped piezoelectric element 2001 of the present invention has a structure shown in Fig. 41. A core electrode (center electrode) 2003 placed in the radial center is covered with a piezoelectric element material (composite piezoelectric layer) 2005 which constitutes a piezoelectric member and is made of piezoelectric ceramic. An outer electrode 2007 is provided around the composite piezoelectric layer 2005, and a coil spring 2011 having a shape-retaining characteristic is provided around the outer electrode 2007. The outermost circumference of the coil spring 2011 is covered with a sheathing layer 2009 such as PVC (polyvinyl chloride) or the like, to thus constitute the cable-shaped piezoelectric element 2001. For instance, sintered fine particles of lead titanate or lead-zirconate-titanate or nonleaded piezoelectric ceramic sintered fine particles such as sodium niobate or the like are used as piezoelectric ceramic. The cable-shaped piezoelectric element 2001 of the present invention has a flexible characteristic as the piezoelectric cable, and hence can be formed into any shape. This cable is also imparted with a shape-retaining characteristic and, therefore, can be formed and retained in the variety of shapes.

In the cable-shaped piezoelectric element 2001, a resin-based material, which can be used up to a temperature of 120°, has been uniquely developed by the present applicant, and possesses heat resistance, is used for the composite piezoelectric layer 2005. The cable-shaped piezoelectric element 2001 can be used at a temperature range (120°C or less), which is higher than the maximum operating temperature of related-art typical polymeric piezoelectric element material (uniaxially-stretched polyvinylidene fluoride) or a piezoelectric element material (a piezoelectric element material formed from chloroprene and piezoelectric ceramic fine particles) i.e., 90°C. The composite piezoelectric layer 2005 is made from resin having flexibility and piezoelectric ceramic and is formed by use of a flexible electrode formed from a coiled metal center electrode and a film-shaped outer electrode, and has the same flexibility as that of an ordinary vinyl cord.

The composite piezoelectric layer 2005 is formed from a composite member formed from resin-based material and piezoelectric ceramic fine particles of 10µm or less. The vibration detection characteristic is realized by ceramic, and flexibility is realized by resin. The composite piezoelectric layer 2005 uses chlorine-based polyethylene as a resin-based material, thereby realizing high heat resistance (120°C), flexibility which enables easy formation, and simple manufacturing processes which do not require a crosslinkage.

The thus-obtained cable-shaped piezoelectric element 2001 has no piezoelectric performance when the composite piezoelectric layer 2005 remains intact. Accordingly, there is required processing (polarization processing) for applying a DC high voltage on the order of volts per millimeter to the composite piezoelectric layer 2005, to thereby impart piezoelectric performance to the composite piezoelectric layer 2005. When minute imperfections, such as cracks, are present in the composite piezoelectric layer 2005, an electric discharge becomes easy to arise among the imperfections, whereby the polarities become likely to induce a short-circuit. Accordingly, a sufficient polarized voltage cannot be applied to the composite piezoelectric layer. However, in the present invention, as a result of establishment of unique polarization steps using an auxiliary electrode which can be brought into intimate contact with the composite piezoelectric layer 2005 of given length, imperfections are detected and avoided, to thus be able to render polarization stable. Thereby, the composite piezoelectric layer can also be made longer to tens of meters or more.

In the cable-shaped piezoelectric element 2001, a coiled metal center electrode is used for the core electrode 2003, and a film-shaped electrode (a three-layer laminate film consisting of aluminum, polyethylene terephthalate, aluminum) is used for the outer electrode 2007. Thereby, adhesion between the composite piezoelectric layer 2005 and the electrode is ensured, thereby facilitating connection of an external lead wire. Thus, a flexible cable-shaped mount configuration becomes feasible.

The core electrode 2003 is formed from a copper-silver alloy coil; the outer electrode 2007 is formed from a three-layer laminate film made of aluminum-polyethylene terephthalate-aluminum; and the composite piezoelectric layer 2005 is formed from polyethylene-based resin and piezoelectric ceramic fine particles. An outer sheath of the composite piezoelectric layer 2005 is formed from thermoplastic, thereby achieving a dielectric constant of 55, an electric charge of 10 to 13C (coulomb)/gf, and a maximum operating temperature of 120°C.

In the cable-shaped piezoelectric element 2001 of the present invention, the coil spring 2011 is wound around the exterior of the outer electrode 2007. The coil spring 2011 is interposed between the outer electrode 2007 and the sheathing layer 2009 in the radial direction of the cable-shaped piezoelectric element 2001. This coil spring 2011 forms a shape-retaining member for retaining the cable-shaped piezoelectric element 2001 in a predetermined shape.

Although wires provided below can be used as the material of the coil spring 2011, the material is not limited to the wire.
WC(80C) (a hard steel wire); SWPA, SWPB (musical instrument wires);
SWOSM-B (a silicon-manganese steel wire); SWOSC-V (a silicon-chromium steel wire);
SUS304-WPB, SUS316-WPA (a stainless steel wire);
BsW (a brass wire); PBW (a phosphor bronze wire)

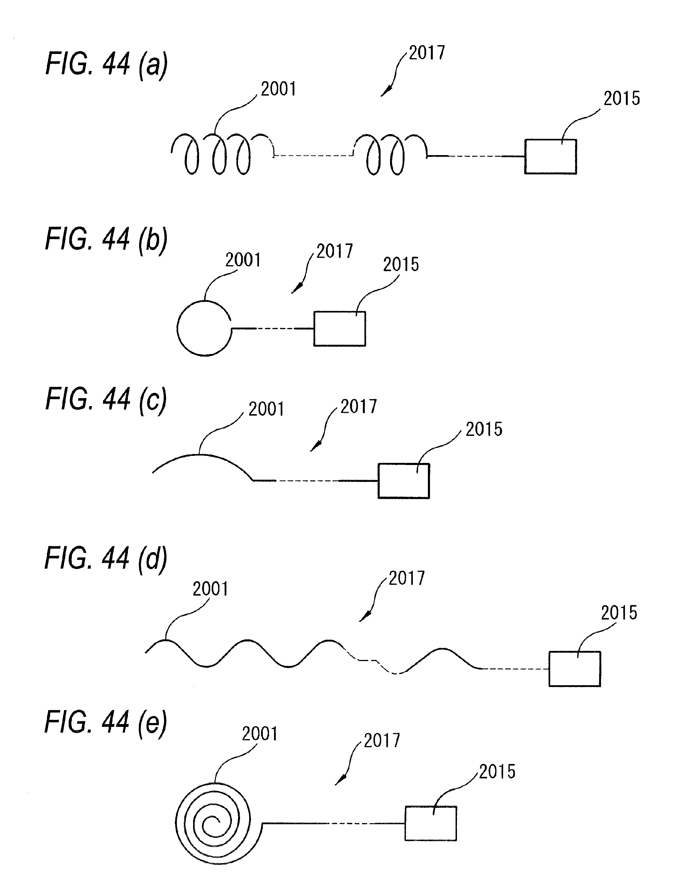

Byway of an example, the above cable-shaped piezoelectric element 2001 is manufactured through the following processes. At the outset, a chlorinated polyethylene sheet and 40% to 70% by volume of piezoelectric ceramic (lead-zirconate-titanate in this embodiment) fine particles are uniformly mixed into the shape of a sheet by means of a rolling technique. After this sheet is finely fragmented into pellets, the pellets are consecutively pushed in conjunction with the core electrode 2003, to thus form the composite piezoelectric layer 2005 (a piezoelectric element material before being subjected to polarization processing). An auxiliary electrode is brought into contact with the outer circumference of the composite piezoelectric layer, and a high voltage is applied between the auxiliary electrode and the core electrode 2003, thereby effecting polarization processing. The outer electrode 2007 is then wound around the composite piezoelectric layer. After the coil spring 2011 has been wound around the outer electrode 2007, the sheathing layer 2009 is continuously extruded while sheathing the outer electrode 2007 and the coil spring 2011. The thus-manufactured cable-shaped piezoelectric element 2001 is processed into various shapes such as those shown in Fig. 44 and the like.

After having been processed once into a predetermined shape, the coil spring 2011 has the shape-retaining characteristic for retaining the shape. Accordingly, this results in the cable-shaped piezoelectric element 2001 itself possessing the shape-retaining characteristic. Even when the cable-shaped piezoelectric element 2001 has been deformed into a desired shape, the property of still attempting to restore its original shape (the residual shape restoration characteristic) becomes substantially zero. Consequently, when predetermined force has been applied to the element from the outside, an output induced by the shape restoration characteristic is zero or becomes substantially zero. Put another way, a correct output induced by only applied force can be obtained stably. Here, the term "substantially zero" signifies that an output induced by the remaining shape restoration characteristic is nominal to such an extent that a correct output is obtained without entailment of a practical problem.

When the piezoelectric ceramic fine particles are added to chlorinated polyethylene, it is preferable to immerse, in advance, the piezoelectric ceramic fine particles into an aqueous solution of titanium coupling agent and to dry the thus-immersed piezoelectric ceramic fine particles. Through this processing, the surface of the piezoelectric ceramic fine particles is coated with a hydrophilic group and a hydrophobic group. The hydrophilic group prevents coagulation of piezoelectric ceramic fine particles, and the hydrophobic group increases wettability of chlorinated polyethylene and the wettability of the piezoelectric ceramic fine particles. Consequently, a large quantity of piezoelectric ceramic fine particles can be uniformly added to the chlorinated polyethylene up to a maximum of 70% by volume. It is found that, in place of immersion of the piezoelectric ceramic fine particles into the aqueous solution of the titanium coupling agent, a titanium coupling agent may be added at the time of rolling of chlorinated polyethylene and the piezoelectric ceramic fine particles, thereby yielding the same effect as that mentioned above. This processing is superior in that special processing for immersing the piezoelectric ceramic fine particles into the aqueous solution of titanium coupling agent is not required. As above, the chlorinated polyethylene also plays a role as binder resin used at the time of mixing of the piezoelectric ceramic fine particles.

In the present embodiment, a single wire formed from copper-basedmetal is used for the core electrode 2003. Further, a strip electrode, which is formed by bonding an aluminum metal film on a polymer layer, is used for the outer electrode 2007, and the outer electrode 2007 is wrapped around the piezoelectric element material 2005. Polyethylene terephthalate (PET) is used as the polymer layer. Since an electrode, which is formed by bonding an aluminum thin film on the PET, is commercially mass-produced and inexpensive, such an electrode is preferable as the outer electrode 2007. When this electrode is connected to an external control circuit, or the like, the electrode can be connected by means of, e.g., caulking or an eyelet. There also be adopted a configuration for soldering a single metal wire or a metal braided wire around the aluminum thin film of the outer electrode 2007, for use in connection with a control circuit or the like. Since soldering becomes available, an attempt to render working efficient can be enabled. In order to shield the cable-shaped piezoelectric element 2001 from electrical noise in the external environment, it is desirable to coil the outer electrode 2007 around the composite piezoelectric layer so as to partially overlap each other.

Arubbermaterial, which is superior to polyvinyl chloride in terms of heat insulation and waterproofing, can also be used as the sheathing layer 2009. In order to make the composite piezoelectric layer 2005 easily deformed by pushing force of an article which contacts the composite piezoelectric layer 2005, the rubber material, which is softer and more flexible than the composite piezoelectric layer 2005, is preferable. Components to be mounted on a vehicle are selected in consideration of heat resistance and cold resistance, and selecting components whose flexibility less drops at -30°C to 85°C is desirable. For instance, it is better to use ethylene-propylene-diene-methylene rubber (EPDM), chloroprene rubber (CR), isobutylene-isoprene rubber (IIR), silicon rubber (Si), thermoplastic elastomer, and the like, as such a rubber material. By means of such a configuration, the smallest curvature of the cable-shaped piezoelectric element 2001 can be reduced up to a radius of 5 mm. When compared with vinyl chloride, greatly superior heat resistance and waterproofing can be ensured.

As mentioned above, the composite piezoelectric member of the cable-shaped piezoelectric element 2001 has both the flexibility of chlorinated polyethylene and the high heat resistance of piezoelectric ceramic. Hence, a drop in sensitivity, which arises at high temperatures as in a related-art piezoelectric sensor using polyvinylidene fluoride as a piezoelectric member, does not occur in the cable-shaped piezoelectric element 2001. Further, in addition to having superior high heat resistance, the cable-shaped piezoelectric element 2001 does not require a vulcanizing process which would be required during molding operation as in the case of rubber such as EPDM. Therefore, there is yielded an advantage of superior production efficiency.

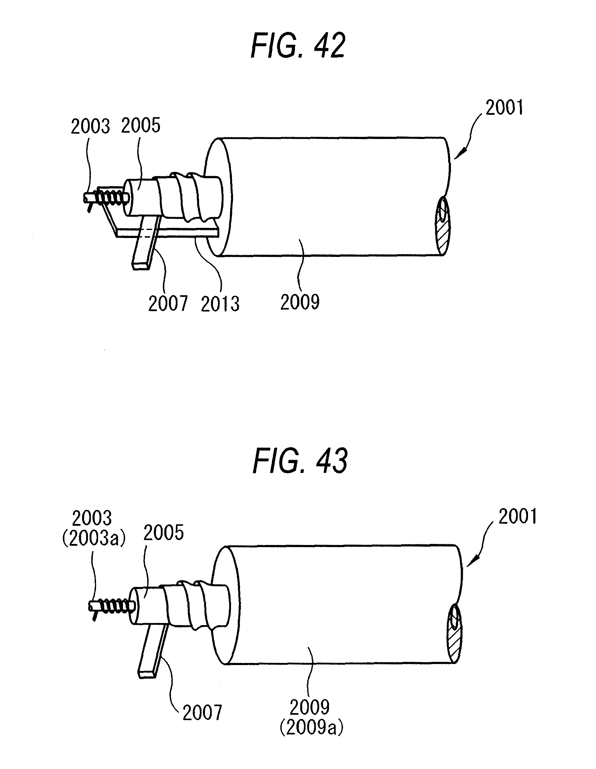

Fig. 42 shows a modification of the cable-shaped piezoelectricelement2001. In this modification, a leaf spring 2013 is placed, in lieu of the coil spring 2011 shown in Fig. 41, adjacent to the outer electrode 2007. Accordingly, the leaf spring 2011 is interposed between the outer electrode 2007 and the sheathing layer 2009 with respect to the radial direction of the cable-shaped piezoelectric element 2001. This leaf spring 2013 constitutes the shape-retaining member for retaining the cable-shaped piezoelectric element 2001 in a predetermined shape, and yields the same advantage as that yielded by the coil spring 2011.

For example, leaf springs provided below can be used as a material for the leaf spring 2013. However, the material is not limited to these leaf springs.
SK5 (a common leaf spring);
SUS301-CSP3/4H, SUS304-CSP3/4H (stainless steel)

Fig. 43 shows another modification of the cable-shaped piezoelectric element 2001. In this modification, an independent shape-retaining member, such as the coil spring 2011 shown in Fig. 41 and the leaf spring 2013 shown in Fig. 42, is not provided. Instead of these shape-retaining members, a core electrode 2003a and/or a sheathing layer 2009a, which have a shape-retaining characteristic, are used. The core electrode 2003a and/or the sheathing layer 2009a yield the same advantage as those yielded by the coil spring 2011 and the leaf spring 2013.

Especially, in the case of a simple member such as the leaf spring 2013, deformation resulting from application of a stress and deformation arising when the member restores a retained shape become constant to a certain extent. Hence, an output is stably obtained. Moreover, so long as the shape has been restored by the next application of a stress, an output having reproducibility is obtained.

In the present embodiment, the core electrode 2003a can be formed from, e.g., a shape memory alloy. An alloy, which restores its original shape even when deformed so long as the alloy is heated to a certain temperature or higher, is called a shape memory alloy. When a low-temperature crystal structure is replaced with a high-temperature crystal structure as a result of an increase in the temperature of the alloy, the original shape is also restored. The temperature where the crystal structure is replaced (a transformation point) usually ranges from 20°C to 100°C. An alloy consisting of nickel and titanium can be used as a material for the alloy. However, no specific limitations are imposed on the type of metal.

In the present embodiment, the sheathing layer 2009a can be formed from, e.g., a heat-shrinkable tube. Polyolefine or hard, shrinkable vinyl chloride can be used as a material for the heat-shrinkable tube. However, no limitations are imposed on the material.

Either of the core electrode 2003a and the sheathing layer 2009a may be imparted with a shape-retaining characteristic. Alternatively, both of them may be imparted with the shape-retaining characteristic.

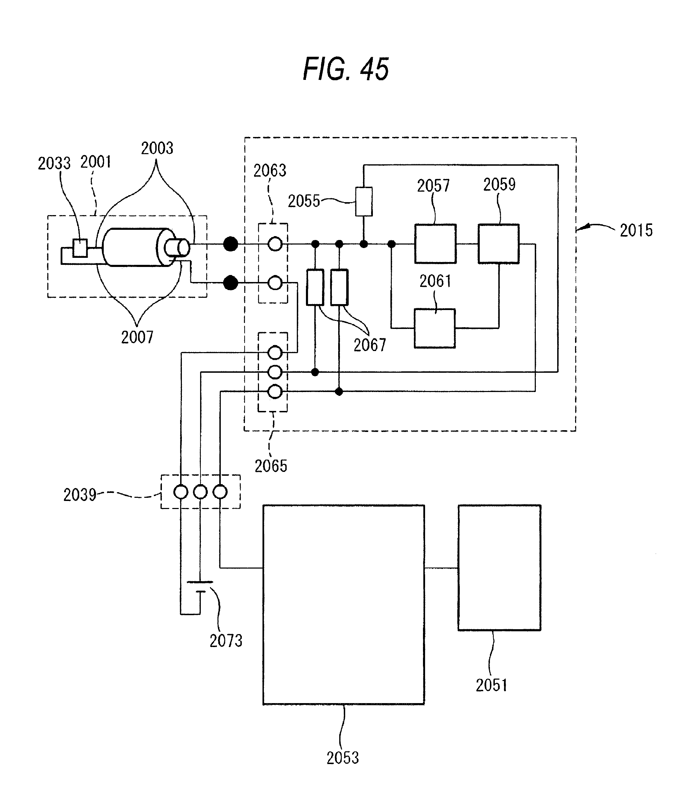

Figs. 44(a) to 44(e) show modifications where the above-described cable-shaped piezoelectric element 2001 is deformed, by utilization of the shape-retaining characteristic thereof, into various shapes. The thus-deformed and retained cable-shaped piezoelectric element 2001 is connected to a predetermined control circuit 2015, to thus constitute a vibration detection sensor 2017. Fig. 45 (a) shows an example coil-shaped piezoelectric element; Fig. 45 (b) shows an example circular piezoelectric element; Fig. 45(c) shows an example segment-shaped piezoelectric element; Fig. 45(d) shows an example corrugated piezoelectric element; and Fig. 45 (e) shows an example helical piezoelectric element. The shapes are not limited to the illustrated examples, and other shapes can also be adopted.

As shown in Fig. 45, the control circuit 2015 for detecting the presence or absence of contact with an object in the signal output from the cable-shaped piezoelectric element 2001 is provided with a beeper 2051 for informing the user of contact with an object and a beeper control section 2053 for controlling operation of the beeper 2051, thereby constituting the vibration detection sensor system.

The control circuit 2015 comprises a voltage-dividing resistor 2055 used for detecting a breakage in the wire of the cable-shaped piezoelectric element 2001; a filtering section 2057 which permits passage of only a predetermined frequency component of the signal output from the cable-shaped piezoelectric element 2001; a determination section 2059 for determining occurrence of contact of the article with the cable-shaped piezoelectric element 2001 in accordance with a signal output from the filtering section 2057; and an anomaly determination section 2061 for determining occurrence of an anomalous breakage in the wire of the core electrode 2003 and the outer electrode 2007, both of which belong to the cable-shaped piezoelectric element 2001, from a voltage value produced by a resistor 2033 for detecting a line breakage and the voltage-dividing resistor 2055. A signal input section 2063, which connects the core electrode 2003 and the outer electrode 2007 to the control circuit 2015 and inputs the signal output from the cable-shaped piezoelectric element 2001 to the control circuit 2015, and a signal output section 2065 for outputting the determination signal generated by the determination section 2059 are provided within the control circuit 2017 while being adjacent to each other. The signal output section 2065 is also connected to a power line for the control circuit 2015 as well as to a ground line. Moreover, the control circuit 2015 has bypass sections 2067, such as a capacitor or the like, which are interposed between the signal input section 2063 and the signal output section 2065 and bypass a high-frequency signal. Further, the signal output section 2065 is provided with a power source 2073 for supplying power to the cable-shaped piezoelectric element via the control circuit 2015. The beeper control section 2053 and the power source 2073 are connected to the signal output section 2065 of the control circuit 2015 by means of a connector 2039.

In order to eliminate external electrical noise, the entirety of the control circuit 2015 is covered with the shield member and, thus, electrically shielded. The outer electrode 2007 remains in electrical conduction with the shielding member of the control circuit 2015, and the cable-shaped piezoelectric element 2001 is also electrically shielded. The input-and-output section of the circuit may also be additionally equipped with a feed-through capacitor, an EMI filter, or the like, as a countermeasure against an intense electric field.

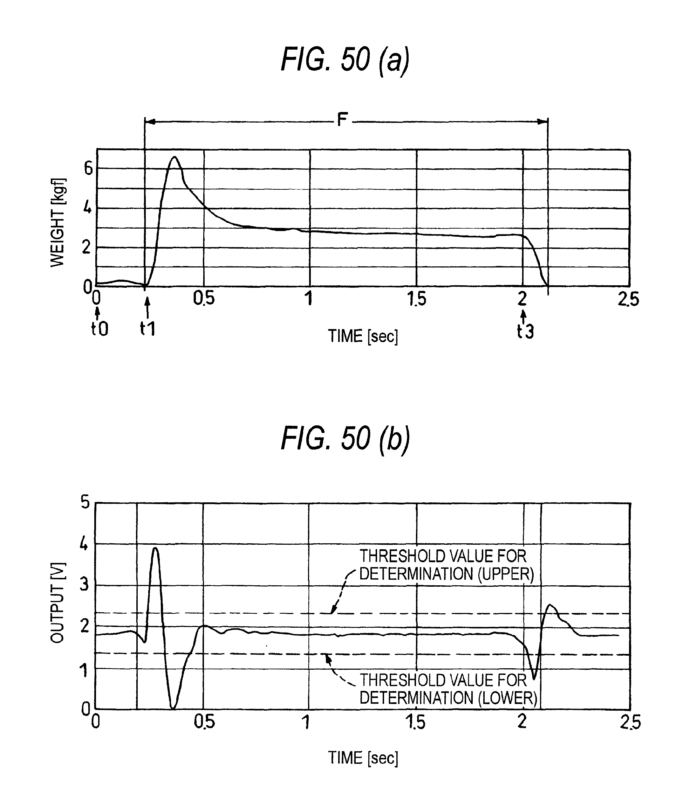

Figs. 50(a) and 50(b) are charts showing loads imposed on the cable-shaped piezoelectric element 2001 and an output from the sensor. Tests on a relationship between the load on the cable-shaped piezoelectric element 2001 and an output from the sensor (hereinafter called a "sensor output") having been conducted by the present applicant show the phenomenon of, when bending load, such as that shown in Fig. 50(a), is imposed on the cable-shaped piezoelectric element 2001, an output from the sensor exhibiting a waveform as shown in Fig. 50(b).

(1) Specifically, when no load was imposed on the cable-shaped piezoelectric element 2001 at time t0, the sensor output exhibited 2(V). (2) When bending load was exerted on the cable-shapedpiezoelectric element 2001 in a given direction at time t1, the sensor output was increased to 4 (V) at the instant when the bending load was exerted but immediately inverted to 0 (V), and again returned to 2 (V). (3) Subsequently, even when the cable-shaped piezoelectric element remained bent, the sensor output kept exhibiting 2 (V). (4) When the cable-shaped piezoelectric element 2001 was restored to its original shape at time t3, the sensor output was decreased to 0.8(V) at that moment but immediately inverted to 2.2(V), and again returned to 2(V).

When the cable-shaped piezoelectric element 2001 was bent in a direction opposite the bending direction in Test (2) through 180 degrees under the same conditions employed during Test (2), the sensor output was decreased to 0 (V) but immediately inverted to 4(V), and again returned to 2(V).

When the cable-shaped piezoelectric element 2001 was bent quickly during Test (2) under the same conditions, the sensor output became larger than that exhibited in Test (2). When the cable-shaped piezoelectric element 2001 was bent slowly, the sensor output became smaller.

The same result was yielded even when the cable-shaped piezoelectric element 2001 was bent in a direction opposite the above bending direction through 180 degrees. Specifically, when the cable-shaped piezoelectric element 2001 was bent quickly, a great fluctuation appeared. When the cable-shaped piezoelectric element 2001 was bent slowly, a small fluctuation appeared. From these results, the longitudinal bending direction of a single cable-shaped piezoelectric element 2001 and an acceleration of bending action are ascertained. Accordingly, an analog input device can be obtained by use of the cable-shaped piezoelectric element 2001.

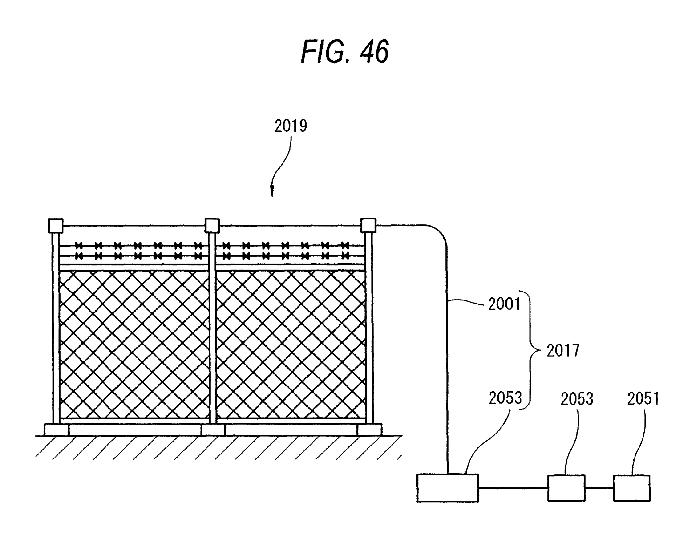

Fig. 46 shows an example where the cable-shaped piezoelectric element 2001 and the vibration detection sensor 2017, both pertaining to the present invention, are used for a crime prevention fence 2019. In the present embodiment, the cable-shaped piezoelectric element 2001 is stretched over the top of the crime prevention fence 2019. When an intruder has touched the cable-shaped piezoelectric element 2001, vibration is detected, and an alarm indicating presence of the intruder is reported to the user by means of the beeper 2051.

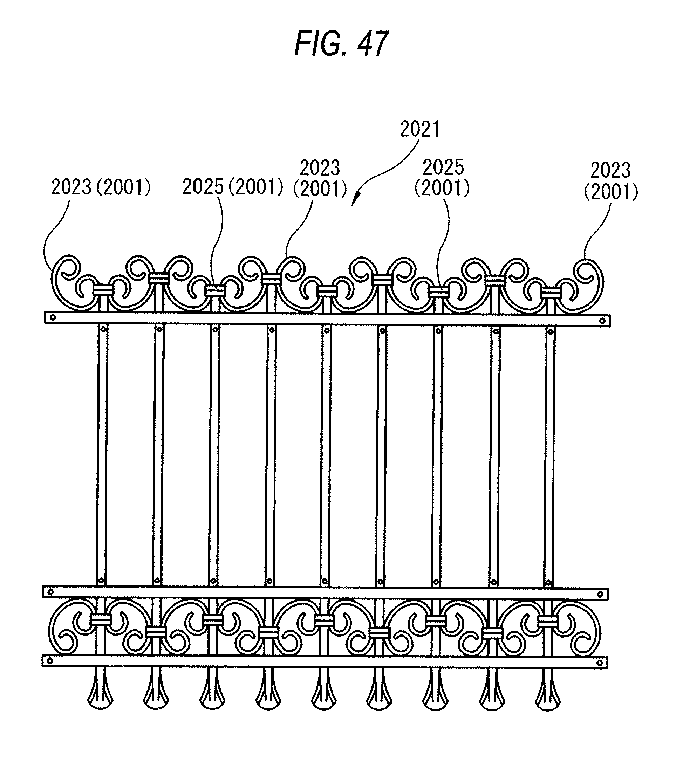

Fig. 47 shows an example where the cable-shaped piezoelectric element 2001 and the vibration detection sensor 2017, both pertaining to the present invention, are used for a crime prevention fence 2021. In the present embodiment, the cable-shaped piezoelectric element 2001 is utilized for a decoration section on top of the crime prevention fence 2021. Specifically, the cable-shaped piezoelectric element 2001 is processed into a predetermined shape consisting of a curve section 2023 and a linear section 2025, and is used in its original form as the decoration section. When an intruder has touched the decoration section, vibration is detected, and an alarm indicating presence of the intruder is reported to the user by means of the beeper 2051.

In the present embodiment, the cable-shaped piezoelectric element 2001 that can accurately detect vibration even when processed into a predetermined shape is applied to a constituent component which constitutes the crime prevention fence 2021. Components constituting the crime prevention fence 2021 and the sensor section can be manufactured from common components. Hence, an attempt can be made to simplify manufacturing processes.

When the cable-shaped piezoelectric element 2001 is applied to such a crime prevention fence, such as that shown in Figs. 46 and 47, unwanted signals induced when birds, or the like, contact the fence, must be eliminated. To this end, it is better to provide the filtering section 2057 shown in Fig. 45 with filtering characteristics of eliminating unwanted signals from the signal output from the cable-shaped piezoelectric element 2001 as well as extracting only a unique frequency component appearing in the signal output from the cable-shaped piezoelectric element 2001 when the cable-shaped piezoelectric element 2001 has been deformed by pushing pressure which has arisen as a result of a contact with a person. The essential requirement to determine the filtering characteristics is to analyze the vibration characteristic which arises when a human body has contacted the piezoelectric element, and to optimize the vibration characteristic.

Using a material having predetermined rigidity for a member or an element used for retaining the cable-shaped piezoelectric element into a predetermined shape is desirable. Thereby, the shape is broken when the person has exerted force on the cable-shaped piezoelectric element. However, the shape is not broken by vibration or physical impact imposed by birds or caused by natural phenomena. Thus, a difference can be created in signal outputs, whereby an intruder and other events can be distinguished from each other. Thus, enhanced accuracy of crime prevention can be expected.

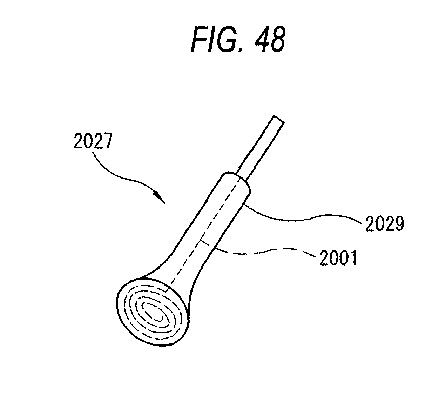

Fig. 48 shows an example where the cable-shaped piezoelectric element 2001 of the present invention is used for a nurse call switch 2027. The cable-shaped piezoelectric element 2001 is processed into a predetermined shape, such as a vortex or the like, and housed in a switch main body 2029. In case of emergency, a patient takes a light grasp on the switch main body 2029, to thus be able to transmit a signal, which reports an abnormal condition, to a call center, whereby a highly-reliable nurse call switch can be provided.

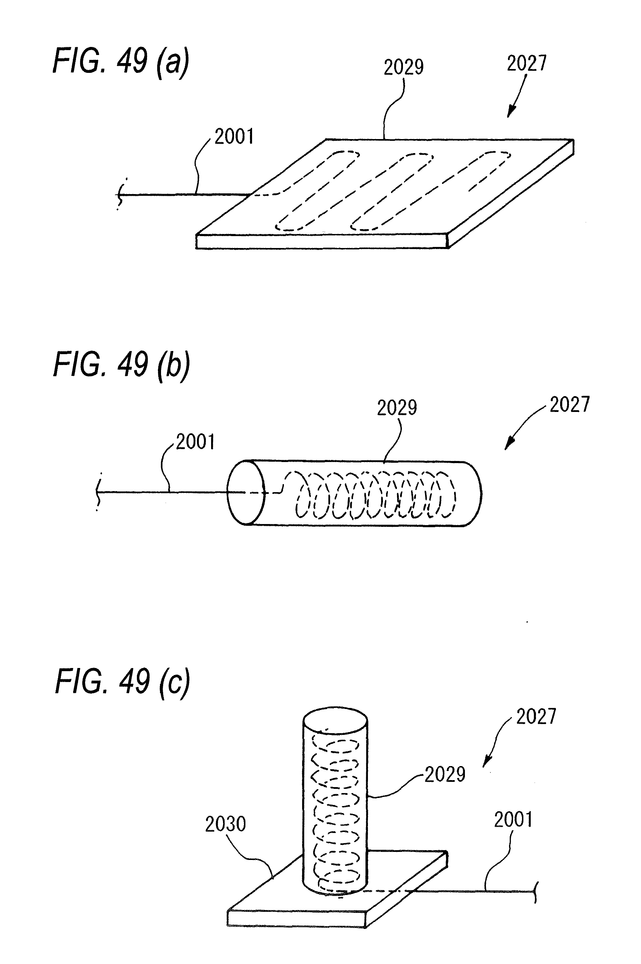

There may also be a case where some patients cannot take a grip on the switch or push a button; the shape of the switch can be formed freely in response to such a circumstance. For instance, the cable-shaped piezoelectric element 2001 can be embedded into the flat main body 2029 such as that shown in Fig. 49(a). The cable-shaped piezoelectric element 2001 can also be embedded into the tube-shaped main body 2029 shown in Fig. 49 (c). In this case, the patient can readily transmit a signal by means of lightly tapping on the switch 2027. The cable-shaped piezoelectric element 2001 can also be embedded into the stick-shaped main body 2029 placed on a mount 2030 such as that shown in Fig. 49(c). In this case, the patient can readily transmit a signal by means of tapping on or swaying the switch 2027.

The above-described crime prevention fence and the nurse call switch are mere illustrations of applications of the cables-shaped piezoelectric element. It goes without saying that, in addition to being applied to the above examples, the cable-shaped piezoelectric element of the present invention can be applied to products for detecting vibration, pressure, and stress.

The above embodiments illustrated the cases where, in order to retain the cable-shaped piezoelectric element 2001 in a predetermined shape, the coils spring 2011 and the leaf spring 2013 are provided, as well as the cases where the core electrode 2003 and/or the sheathing layer 2009 are/is imparted with the shape-retaining characteristic. All piezoelectric elements, which assume the shape of a cable and have a predetermined shape-retaining characteristic, can be included in the present invention.

Although various embodiments of the present invention have been described thus far, the present invention is not limited to the items described in the embodiments . Alternations or applications, which will be made by the persons skilled in the art on the basis of the scope of the claims, descriptions of the specification, and known techniques, are expected by the present invention; and fall within the scope where the protection of the invention is sought.

The present invention has been described in detail and by reference to the specific embodiments. However, it is obvious for persons versed in the art to be able to make alternations or modifications to the present invention without departing from the scope and sprit of the present invention.
The present invention claims priority to Japanese Patent Application No. 2004-263973 filed on September 10, 2004; No. 2004-263974 filed on September 10, 2004; and No. 2004-264179 filed on September 10, 2004, all of which are incorporated herein by reference in their entireties.

### INDUSTRIAL APPLICABILITY

As above, the vibration detection sensor of the present invention can be applied to equipment or a field which requires accurate detection and measurement of vibration.

## Claims

1. A vibration detection sensor comprising:
a substrate; and
a cable-shaped piezoelectric element serially connected to at least one end of the substrate,
wherein the cable-shaped piezoelectric element comprises, in a radial direction thereof:
a core electrode;
a piezoelectric member disposed around the core electrode;
an outer electrode disposed around the piezoelectric member; and
a sheathing layer disposed around the outer electrode.

2. The vibration detection sensor according to claim 1, wherein the cable-shaped piezoelectric element has a bend section.

3. The vibration detection sensor according to claim 1 or 2, wherein a weight is fastened to at least a portion of the cable-shaped piezoelectric element.

4. The vibration detection sensor according to claim 1, wherein the cable-shaped piezoelectric element is bent so as to become substantially circular within a plane substantially parallel to a main plane of the substrate, and has a weight fastened to an open end thereof opposite the end thereof fixed to the substrate.

5. The vibration detection sensor according to claim 1, wherein the cable-shaped piezoelectric element is connected to the substrate while both ends thereof are arranged in substantially parallel to each other, and an intermediate portionbetweenboth ends is formed into a substantially circular shape.

6. The vibration detection sensor according to claim 1, wherein the cable-shaped piezoelectric element is formed into the shape of a coil and provided at substantially right angles on the substrate.

7. The vibration detection sensor according to claim 1, wherein the cable-shaped piezoelectric element is formed into the shape of a coil and extended from the substrate such that the diameter of the coil increases with increasing distance from the substrate.

8. The vibration detection sensor according to claim 1,
wherein a through hole is formed in the substrate,
wherein the cable-shaped piezoelectric element is connected to the substrate so as to become substantially parallel to a principal plane of the substrate within the through hole, and
wherein a weight is fastened to an open end of the cable-shaped piezoelectric element opposite an end thereof fixed to the substrate.

9. The vibration detection sensor according to claim 1,
wherein a through hole is formed in the substrate,
wherein the cable-shaped piezoelectric element is connected to the substrate so as to be come substantiallyparallel to a principal plane of the substrate within the through hole,
wherein the cable-shaped piezoelectric element is bent into substantially U-shape, and
wherein the cable-shaped piezoelectric element is at both ends thereof fixed to the substrate.

10. The vibration detection sensor according to any one of claims 1 through 9, further comprising an enclosure for housing the substrate and the cable-shaped piezoelectric element.

11. The vibration detection sensor according to any one of claims 1 through 9, wherein the cable-shaped piezoelectric element is connected to the substrate such that the cable-shaped piezoelectric element is suspended from a lower surface of the substrate so as to extend downward.

12. The vibration detection sensor according to claim 1, wherein the cable-shaped piezoelectric element has a shape-retaining characteristic.

13. The vibration detection sensor according to any one of claims 1 through 12, wherein the piezoelectric member comprises resin and piezoelectric ceramic.

14. A pressure-sensitive switch comprising a piezoelectric cable which has a piezoelectric element structure formed from piezoelectric ceramic fine particles and resin-based material,
wherein at least a portion of the piezoelectric cable is caused to protrude from a supporting face,
wherein the protruding portion is bent into abend section, and
wherein a control circuit is connected to abase end portion of the piezoelectric cable.

15. The pressure-sensitive switch according to claim 14,
wherein a clearance is provided between the bend section of the piezoelectric cable and the supporting face.

16. The pressure-sensitive switch according to claim 14 or 15, wherein the bend section of the piezoelectric cable is bend at a single curvature.

17. The pressure-sensitive switch according to any one of claims 14 to 17, further comprising fixing means for fixing a leading end portion of the piezoelectric cable.

18. A cable-shaped piezoelectric element having a shape-retaining characteristic and comprising along a radial direction thereof at least:
a core electrode;
a piezoelectric member disposed around the core electrode;
an outer electrode disposed around the piezoelectric element; and
a sheathing layer provided around the outer electrode.

19. A cable-shaped piezoelectric element comprising along a radial direction thereof:
a core electrode;
a piezoelectric member disposed around the core electrode;
an outer electrode disposed around the piezoelectric member;
a sheathing layer provided around the outer electrode; and
a shape-retaining member which is interposed between the outer electrode and the sheathing layer in the radial direction and retains the cable-shaped piezoelectric element in a predetermined shape.

20. The Cable-shaped piezoelectric element according to claim 19, wherein the shape-retaining member is at least one of a leaf spring and a coil spring.

21. A cable-shaped piezoelectric element comprising along a radial direction thereof:
a core electrode;
a piezoelectric member disposed around the core electrode;
an outer electrode disposed around the piezoelectric member; and
a sheathing layer provided around the outer electrode,
wherein the core electrode has a shape-retaining characteristic for retaining the cable-shaped piezoelectric element in a predetermined shape.

22. Thecable-shaped piezoelectric elementaccordingto claim 21, wherein the core electrode is formed from a shape memory alloy.

23. A cable-shaped piezoelectric element comprising along a radial direction thereof:
a core electrode;
a piezoelectric member disposed around the core electrode;
an outer electrode disposed around the piezoelectric member; and
a sheathing layer provided around the outer electrode,
wherein the sheathing layer has a shape-retaining characteristic for retaining the cable-shaped piezoelectric element in a predetermined shape.

24. The cable-shaped piezoelectric element according to claim 23, wherein the sheathing layer is formed from a heat-shrinkable tube.

25. The cable-shaped piezoelectric element according to any one of claims 19 to 24, wherein the piezoelectric member is formed from resin and piezoelectric ceramic.

26. The cable-shaped piezoelectric element according to any one of claims 19 to 25, wherein the predetermined shape is at least one of the shape of a coil, a circular shape, the shape of a segment, a corrugated shape, and the shape of a vortex.

27. A vibration detection sensor comprising:
the cable-shaped piezoelectric element according to any one of claims 18 to 26; and
a control circuit for detecting a signal output from the cable-shaped piezoelectric element.

28. A crime prevention fence comprising:
the cable-shaped piezoelectric element defined in any one of claims 18 to 26.

29. A nurse call switch comprising:
the cable-shaped piezoelectric element defined in any one of claims 18 to 26.
